(19) Europäisches Patentamt
European Patent Office
Office européen des brevets

(11) **EP 4 707 837 A1**

(12) **EUROPEAN PATENT APPLICATION**
published in accordance with Art. 153(4) EPC

(43) Date of publication:
**11.03.2026 Bulletin 2026/11**

(21) Application number: **24874896.4**

(22) Date of filing: **25.09.2024**

(51) International Patent Classification (IPC):
*G01R 31/396* (2019.01)     *G01R 31/367* (2019.01)
*G01R 31/392* (2019.01)     *G01R 31/3842* (2019.01)
*G01R 31/3828* (2019.01)     *B60L 58/16* (2019.01)
*H01M 10/052* (2010.01)     *G01R 31/36* (2020.01)
*G01R 31/385* (2019.01)     *H01M 10/48* (2006.01)

(52) Cooperative Patent Classification (CPC):
**B60L 58/16; G01R 31/36; G01R 31/367;
G01R 31/3828; G01R 31/3842; G01R 31/385;
G01R 31/392; G01R 31/396; H01M 10/052;
H01M 10/48**

(86) International application number:
**PCT/KR2024/014522**

(87) International publication number:
**WO 2025/075338 (10.04.2025 Gazette 2025/15)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **06.10.2023 KR 20230133644
09.11.2023 KR 20230154880**

(71) Applicant: **LG Energy Solution, Ltd.
Seoul 07335 (KR)**

(72) Inventors:
• **PARK, Jun-Cheol
Daejeon 34122 (KR)**
• **KIM, Young-Deok
Daejeon 34122 (KR)**
• **KIM, Ji-Yeon
Daejeon 34122 (KR)**

(74) Representative: **Goddar, Heinz J.
Boehmert & Boehmert
Anwaltspartnerschaft mbB
Pettenkoferstrasse 22
80336 München (DE)**

(54) **BATTERY DIAGNOSIS APPARATUS AND BATTERY DIAGNOSIS METHOD**

(57) Disclosed is a battery diagnosis apparatus and a battery diagnosis method. The battery diagnosis apparatus includes a processor configured to control a stimulation application device to intermittently apply a second electric stimulation greater than a first electric stimulation to a target cell during a state change period, and a communication unit configured to obtain current time series data during the state change period and voltage time series data representing a change history of a full-cell voltage of the target cell during rest periods of the second electric stimulation applied in the state change period. The processor generates a measurement full-cell profile based on the current time series data and the voltage time series data, and analyzes the measurement full-cell profile to estimate a negative electrode loading amount.

EP 4 707 837 A1

FIG. 1

**Description**

TECHNICAL FIELD

The present disclosure relates to technology for non-destructively diagnosing a state of a battery.
The present application claims priority to Korean Patent Application No. 10-2023-0154880 filed on November 9, 2023, and Korean Patent Application No. 10-2023-0133644 filed on October 6, 2023, in the Republic of Korea, the disclosures of which are incorporated herein by reference.

BACKGROUND ART

Recently, there has been a rapid increase in the demand for portable electronic products such as laptop computers, video cameras and mobile phones, and with the extensive development of electric vehicles, accumulators for energy storage, robots and satellites, many studies are being made on high performance batteries that can be repeatedly recharged.
Currently, commercially available batteries include nickel-cadmium batteries, nickel-hydrogen batteries, nickel-zinc batteries, lithium batteries and the like, and among them, lithium batteries have little or no memory effect, and thus they are gaining more attention than nickel-based batteries for their advantages that recharging can be done whenever it is convenient, the self-discharge rate is very low and the energy density is high.
Although much research is being done on these batteries in terms of increasing capacity and density, improvements in lifespan and safety are also important. In order to improve battery safety, the current state of the battery must be accurately diagnosed.
Accurately diagnosing the internal state of a battery is essential for safety and long lifespan of the battery. To diagnose the internal state of a battery without disassembly, relationship data (which can be referred to as a full-cell profile or the like) showing the correspondence between capacity and voltage is mainly used.
Conventionally, the full-cell profile is obtained by repeating the procedure of measuring voltage and capacity of a battery at short intervals while a constant electric stimulation (e.g., constant current charging or discharging) is applied to the battery. However, in order to minimize polarization (or overpotential) that causes a decrease in diagnostic accuracy, the level of electric stimulation applied to the target cell must be lowered, which has the limitation that it takes excessive time to acquire the full-cell profile. Meanwhile, although high-level electric stimulation is advantageous in terms of shortening the time, it is not possible to guarantee the accuracy of the diagnostic result because the high-level electric stimulation is accompanied by a severe polarization phenomenon.

DISCLOSURE

Technical Problem

The present disclosure is designed to solve the problems of the related art, and therefore the present disclosure is directed to providing a battery diagnosis apparatus and a battery diagnosis method, which may obtain relationship data representing the correspondence between capacity and voltage of a target cell by using a method of intermittently applying high-level electric stimulation to the target cell, and diagnose a negative electrode degradation state of the target cell (a negative electrode loading amount, a negative electrode loss rate, etc., explained later) based on the obtained relationship data.
These and other objects and advantages of the present disclosure may be understood from the following detailed description and will become more fully apparent from the exemplary embodiments of the present disclosure. Also, it will be easily understood that the objects and advantages of the present disclosure may be realized by the means shown in the appended claims and combinations thereof.

Technical Solution

In one aspect of the present disclosure, there is provided a battery diagnosis apparatus comprising: a processor configured to control a stimulation application device to intermittently apply a second electric stimulation greater than a first electric stimulation to a target cell during a state change period until an electrical state of the target cell, which is a battery cell to be diagnosed, changes from an initial state to a target state; and a communication unit configured to obtain current time series data representing a change history of a current of the target cell during the state change period and voltage time series data representing a change history of a full-cell voltage of the target cell during rest periods of the second electric stimulation given in the state change period. The processor is configured to: generate a measurement full-cell profile representing a correspondence between a capacity and the full-cell voltage of the target cell based on the current time series data and the voltage time series data, and estimate a negative electrode loading amount representing an amount of negative electrode active material per unit area of a negative electrode of the target cell by analyzing the measurement full-cell profile.

The first electric stimulation may be an electric stimulation that causes a difference between OCV and CCV equal to or smaller than a reference value in the target cell. The second electric stimulation may be an electric stimulation that causes a difference between the OCV and the CCV greater than the reference value in the target cell.

The first electric stimulation may be charging using a first current rate, and the second electric stimulation may be charging using a second current rate that is greater than the first current rate.

The first electric stimulation may be a discharge using a first current rate, and the second electric stimulation may be a discharge using a second current rate that is greater than the first current rate.

The voltage time series data may be measurement values of the full-cell voltage during the rest periods of the second electric stimulation, which are arranged in time order as OCV of the target cell.

The processor may be configured to control the stimulation application device to initiate a rest period of the second electric stimulation whenever a current integration value of the current changes by a threshold integration value.

The processor may be configured to control the stimulation application device to resume application of the second electric stimulation when a reference time passes from an initiation time point of the rest period of the second electric stimulation.

The processor may be configured to determine a negative electrode loss rate of the target cell based on an estimation value of the negative electrode loading amount.

The processor may be configured to limit at least one of an allowable voltage range and an allowable SOC range for the target cell based on an estimation value of the negative electrode loading amount.

In another aspect of the present disclosure, there is also provided a charging station, comprising the battery diagnosis apparatus.

In still another aspect of the present disclosure, there is also provided a cloud server, comprising the battery diagnosis apparatus.

In still another aspect of the present disclosure, there is also provided a battery diagnosis method, comprising: controlling a stimulation application device to intermittently apply a second electric stimulation greater than a first electric stimulation to a target cell during a state change period until an electrical state of the target cell, which is a battery cell to be diagnosed, changes from an initial state to a target state; obtaining current time series data representing a change history of a current of the target cell during the state change period and voltage time series data representing a change history of a full-cell voltage of the target cell during rest periods of the second electric stimulation given in the state change period; generating a measurement full-cell profile representing a correspondence between a capacity and the full-cell voltage of the target cell based on the current time series data and the voltage time series data; and estimating a negative electrode loading amount representing an amount of negative electrode active material per unit area of a negative electrode of the target cell by analyzing the measurement full-cell profile.

The voltage time series data may be measurement values of the full-cell voltage during the rest periods of the second electric stimulation, which are arranged in time order as OCV of the target cell.

The battery diagnosis method may further comprise determining a negative electrode loss rate of the target cell based on an estimation value of the negative electrode loading amount.

The battery diagnosis method may further comprise limiting at least one of an allowable voltage range and an allowable SOC range for the target cell based on an estimation value of the negative electrode loading amount.

Advantageous Effects

According to at least one of the embodiments of the present disclosure, it is possible to obtain relationship data representing the correspondence between capacity and voltage of a target cell by using a method of intermittently applying high-level electric stimulation to the target cell, and diagnose a negative electrode degradation state of the target cell (a negative electrode loading amount, a negative electrode loss rate, etc., explained later) based on the obtained relationship data.

That is, by using high-level electric stimulation to change the electrical state of the target cell, the time required to obtain relationship data may be shortened, while also preventing a decrease in diagnostic accuracy due to excessive polarization caused by intermittent application of electric stimulation.

The effects of the present disclosure are not limited to the effects mentioned above, and these and other effects will be clearly understood by those skilled in the art from the appended claims.

DESCRIPTION OF DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.

FIG. 1 is a drawing exemplarily showing the configuration of an electric vehicle and a charging station including a battery diagnostic circuit according to the present disclosure.

FIG. 2 is a graph referenced to describe an example of a reference positive electrode profile and a reference negative electrode profile, respectively.

FIGS. 3a and 3b are graphs referenced to exemplarily describe the process of obtaining a measurement full-cell profile of a target cell.

FIGS. 4 to 6 are drawings referenced to describe an example of a procedure of generating a comparison full-cell profile used for comparison with the measurement full-cell profile according to an embodiment of the present disclosure.

FIGS. 7 to 9 are drawings referenced to describe another example of the procedure for generating a comparison full-cell profile used for comparison with the measurement full-cell profile according to an embodiment of the present disclosure.

FIG. 10 is a flowchart referenced to exemplarily describe a battery diagnosis method according to the first embodiment of the present disclosure.

FIG. 11 is a flowchart referenced to exemplarily describe a battery diagnosis method according to the second embodiment of the present disclosure.

FIG. 12 is a drawing referenced to describe a procedure of correcting voltage time series data performed in Step S1122 of FIG. 11.

## BEST MODE

Hereinafter, preferred embodiments of the present disclosure will be described in detail with reference to the accompanying drawings. Prior to the description, it should be understood that the terms used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation.

Therefore, the description proposed herein is just a preferable example for the purpose of illustrations only, not intended to limit the scope of the disclosure, so it should be understood that other equivalents and modifications could be made thereto without departing from the scope of the disclosure.

The terms including the ordinal number such as "first", "second" and the like, are used to distinguish one element from another among various elements, but not intended to limit the elements by the terms.

Unless the context clearly indicates otherwise, the terms "comprise" and "include" when used in this specification, specify the presence of stated elements, but do not preclude the presence or addition of one or more other elements. Additionally, the term "... unit" as used herein refers to a processing unit of at least one function or operation, and may be implemented by hardware and software either alone or in combination.

In addition, throughout the specification, it will be further understood that when an element is referred to as being "connected to" another element, it can be directly connected to the other element or intervening elements may be present.

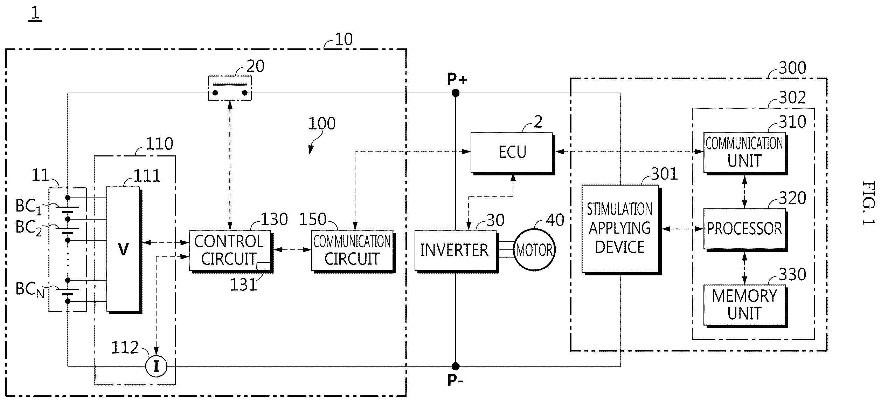

FIG. 1 is a drawing exemplarily showing the configuration of an electric vehicle and a charging station including a battery diagnostic circuit according to the present disclosure.

Referring to FIG. 1, the electric vehicle 1 includes a vehicle controller 2, a battery pack 10, an inverter 30, and an electric motor 40. Charging and discharging terminals P+ and P- of the battery pack 10 may be electrically connected to a charging station 300 through a charging cable or the like.

The vehicle controller 2 (e.g., ECU: Electronic Control Unit) is configured to transmit a key-on signal to the battery management system 100 in response to that a start button (not shown) provided in the electric vehicle 1 is switched to an ON position by a user. The vehicle controller 2 is configured to transmit a key-off signal to the battery management system 100 in response to that the start button is switched to an OFF position by the user. The charging station 300 may communicate with the vehicle controller 2 and supply a charging power selected from a constant power, a constant current, and a constant voltage through the charging and discharging terminals P+ and P- of the battery pack 10.

The battery pack 10 includes a battery 11, a relay 20, and a battery management system 100.

The battery 11 includes at least one battery cell BC. In FIG. 1, the battery 11 is exemplarily shown as including a plurality of battery cells ($BC_1$ to $BC_N$, N is a natural number of 2 or more) connected in series. The plurality of battery cells ($BC_1$ to $BC_N$) may be provided to have the same electrochemical specifications. Hereinafter, when explaining features common to the plurality of battery cells ($BC_1$ to $BC_N$), the reference sign 'BC' will be endowed to the battery cell. The charging station 300 may execute charging and discharging cycles necessary to diagnose the battery cell BC through collaboration with the inverter 30 having a discharging function.

The type of the battery cell BC is not specially limited as long as it is an electrochemical element capable of repeatedly charging and discharging. The battery cell BC is a target of diagnosis by the charging station.

The relay 20 is electrically connected in series to the battery 11 through a power path that connecting the battery 11 and the inverter 30. In FIG. 1, the relay 20 is illustrated as connected between the positive electrode terminal of the battery 11 and the charging and discharging terminal P+. The relay 20 is controlled to turn on and off in response to a switching signal from the battery management system 100. The relay 20 may be a mechanical contactor turned on and off by the magnetic force of a coil, or a semiconductor switch such as a MOSFET (Metal Oxide Semiconductor Field Effect transistor).

The inverter 30 is provided to convert DC current from the battery 11 included in the battery pack 10 into AC current in response to a command from the battery management system 100 or the vehicle controller 2. The electric motor 40 is driven using AC current power from the inverter 30. As the electric motor 40, for example, a three-phase AC current motor may be used. The components in the electric vehicle 1 that receive a discharging power from the battery 11, such as the inverter 30 and the electric motor 40, may be collectively referred to as electric loads.

The battery management system 100 includes a sensing unit 110 and a control circuit 130. The battery management system 100 may further include a communication circuit 150.

The sensing unit 110 includes a voltage sensor 111. The sensing unit 110 may further include a current sensor 112.

The voltage sensor 111 is connected to the positive electrode terminal and the negative electrode terminal of the battery cell BC, and is configured to detect the voltage across both ends of the battery cell BC (also referred to as 'full-cell voltage') and generate a voltage signal representing the detection value of the detected voltage. The voltage sensor 111 may be implemented as one or a combination of two or more of known voltage detection elements such as a voltage measurement IC.

The current sensor 112 is connected in series to the battery 11 through a current path between the battery 11 and the inverter 30. The current sensor 112 is configured to detect the current (also referred to as a 'charging and discharging current') flowing through the battery 11 and generate a current signal representing the detection value of the detected current. Since the plurality of battery cells ($BC_1$ to $BC_N$) are connected in series, the current flowing in the battery 11 is the same as the current flowing in the battery cell BC. The current sensor 112 may be implemented as one or a combination of two or more of known current detection elements such as a shunt resistor, a Hall effect element, etc.

The communication circuit 150 is configured to support wired or wireless communication between the control circuit 130 and the vehicle controller 2. The wired communication may be, for example, CAN (Controller Area Network) communication, and the wireless communication may be, for example, ZigBee or Bluetooth communication. The type of communication protocol is not particularly limited as long as it supports wired and wireless communication between the control circuit 130 and the vehicle controller 2. The communication circuit 150 may include an output device (e.g., a display, a speaker) that provides information received from the control circuit 130 and/or the vehicle controller 2 in a form recognizable to the user (driver).

The control circuit 130 is operably coupled to the relay 20, the voltage sensor 111, and the communication circuit 150. The operable coupling of two components means that the two components are connected directly or indirectly to enable transmission and reception of signals in one direction or two directions.

The control circuit 130 may collect the voltage signal from the voltage sensor 111 and the current signal from the current sensor 112. In this specification, the detection signal may a term referring only to a voltage signal, or a term collectively referring to a voltage signal and a current signal. That is, the control circuit 130 may convert each analog signal collected from the sensors 111 and 112 into a digital value using an ADC (Analog to Digital Converter) provided therein and record the digital value. Alternatively, each of the voltage sensor 111 and the current sensor 112 may include an ADC therein and transmit a digital value to the control circuit 130.

The control circuit 130 may be called a 'battery controller', and may be implemented in hardware using at least one of application specific integrated circuits (ASICs), digital signal processors (DSPs), digital signal processing devices (DSPDs), programmable logic devices (PLDs), field programmable gate arrays (FPGAs), microprocessors or electrical units for performing the other functions.

The memory 131 may include, for example, at least one type of storage medium of flash memory type, hard disk type, Solid State Disk (SSD) type, Silicon Disk Drive (SDD) type, multimedia card micro type, random access memory (RAM), static random access memory (SRAM), read-only memory (ROM), electrically erasable programmable read-only memory (EEPROM) or programmable read-only memory (PROM). The memory 131 may store data and programs required for calculation operations by the control circuit 130. The memory 131 may store data representing the result of a calculation operation performed by the control circuit 130.

When the relay 20 is turned on, the battery 11 goes into a charging mode or a discharging mode. If the relay 20 is turned off while the battery 11 is being used in the charging mode or the discharging mode, the battery 11 switches to a rest mode.

The control circuit 130 may turn on the relay 20 in response to a key-on signal. The control circuit 130 may turn off the relay 20 in response to a key-off signal. The key-on signal is a signal that requests switching from the rest mode to the charging or discharging mode. The key-off signal is a signal that requests switching from the charging or discharging mode to the resting mode. Alternatively, the vehicle controller 2 may be responsible for turning on/off the relay 20 instead of the control circuit 130.

In this specification, time series data of a certain parameter indicates the change history of the parameter over time. In addition, a profile (or curve), which represents the correspondence of any two parameters obtained at the same timing in the same period, may be a mapping of two time series data of two parameters so that they may be expressed in the form of a two-dimensional graph, or may be a polynomial equation obtained by applying a predetermined curve fitting logic to the set of two mapped time series data. Here, the degree of the highest term of the polynomial equation may be predetermined.

The battery diagnosis apparatus 302 includes a communication unit 310, a processor 320, and a memory unit 330.

The charging station 300 may include a stimulation applying device 301 and a battery diagnosis apparatus 302. Alternatively, the battery diagnosis apparatus 302 may be configured independently from the charging station 300. For example, the battery diagnosis apparatus 302 may be provided to be included in a cloud server (not shown). The cloud server may be placed remotely from the charging station 300. In this case, the communication unit 310 of the battery diagnosis apparatus 302 may perform diagnostic procedures for a target cell through remote communication with the stimulation applying device 301 and/or the electric vehicle 1.

The battery diagnosis apparatus 302 may be included in the battery pack 10, and in this case, the battery management system 100 may be omitted from the battery pack 10. In other words, the processor 320 may be responsible for all functions of the control circuit 130 of the battery management system 100. For example, the communication unit 310 may be included as a sub-component of the processor 320 and may be responsible for all functions of the communication circuit 150 of the battery management system 100. Also, the communication unit 310 may collect voltage measurement information and current measurement information from the sensing unit 110.

The stimulation applying device 301 may include a charger that provides a charging power for normal charging of the battery pack 10. The stimulation applying device 301, alone or in collaboration with the inverter 30, may apply various electric stimulation to the battery cell BC for diagnosis of the battery cell BC.

The communication unit 310 is configured to support wired or wireless communication between the processor 320 and the vehicle controller 2. The communication unit 310 may transmit the result of diagnosis for the battery cell BC performed by the processor 320 to the electric vehicle 1.

In terms of hardware, the processor 320 may be implemented using at least one of ASICs (application specific integrated circuits), DSPs (digital signal processors), DSPDs (digital signal processing devices), PLDs (programmable logic devices), FPGAs (field programmable gate arrays), microprocessors, and electrical units for performing other functions.

The memory unit 330 may include, for example, at least one type of storage medium among flash memory type, hard disk type, Solid State Disk (SSD) type, Silicon Disk Drive (SDD) type, multimedia card micro type, random access memory (RAM), static random access memory (SRAM), read-only memory (ROM), electrically erasable programmable read-only memory (EEPROM) or programmable read-only memory (PROM). The memory unit 330 may store data and programs required for diagnostic procedures performed by the processor 320. The memory unit 330 may store data representing the result of a calculation operation by the processor 320. The memory unit 330 may store data sets and software used to diagnose the degradation state of the battery cell BC.

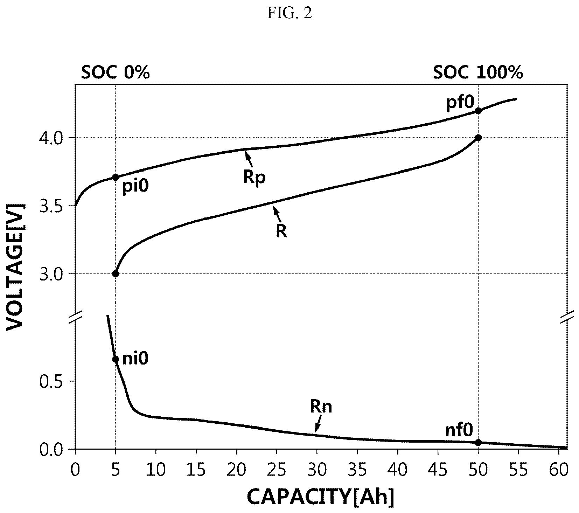

FIG. 2 is a graph referenced to describe an example of each of a reference positive electrode profile and a reference negative electrode profile. In the graph of FIG. 2, the horizontal axis (X-axis) represents capacity (Ah) and the vertical axis (Y-axis) represents voltage.

Referring to FIG. 2, the memory unit 330 may store a reference positive electrode profile Rp and a reference negative electrode profile Rn. The reference cell may be a coin-type cell including a positive electrode half-cell and a negative electrode half-cell, or may be a 3-electrode cell. Hereinafter, the positive electrode of the reference cell and the positive electrode half-cell will be described in equivalent terms, and the negative electrode of the reference cell and the negative electrode half-cell will be described in equivalent terms.

The reference positive electrode profile Rp may be a profile representing the correspondence between the positive electrode voltage and the capacity of the reference cell. The positive electrode voltage of the reference cell refers to a potential difference between the potential of a reference electrode (not shown) and the potential of the positive electrode of the reference cell. The positive electrode profile may also be referred to as a positive electrode half-cell profile.

The reference negative electrode profile Rn may be a profile representing the correspondence between the negative electrode voltage and the capacity of the reference cell. The negative electrode voltage of the reference cell refers to a potential difference between the potential of the reference electrode and the potential of the negative electrode of the reference cell. The negative electrode profile may also be referred to as a negative electrode half-cell profile.

The potential of the reference electrode may be, for example, a redox potential of lithium. The positive electrode voltage may be simply referred to as a positive electrode potential, and the negative electrode voltage may simply be referred to as a negative electrode potential.

Each of the positive electrode voltage and the negative electrode voltage may be an open circuit voltage (OCV) or a closed circuit voltage (CCV).

A first charge protocol or a first discharge protocol may be used to obtain the open circuit voltage of each of the positive electrode and the negative electrode of the reference cell. The first charge protocol may be an intermittent charging method in which constant current charging using the first current rate and resting are alternately performed. The first discharge protocol may be an intermittent discharging method in which constant current discharge using the first current rate and resting are alternately performed. The first current rate (e.g., 0.05 C) may be determined in advance to be larger than the second current rate (e.g., 3.0 C), explained later.

For example, whenever the charging time by the constant current charging of the first charge protocol passes by a set time or the charging capacity of the reference cell increases by a set capacity, the charging of the reference cell may be stopped for a predetermined rest time and then the constant current charging may be resumed. The charging capacity may be calculated by periodically or aperiodically accumulating the sample values of the charging current.

As another example, whenever the discharging time by the constant current discharging of the first discharge protocol passes by a set time or the discharge capacity of the reference cell decreases by a set capacity, the discharging of the reference cell may be stopped for a predetermined rest time and then the constant current discharging may be resumed. The discharging capacity may be calculated by periodically or aperiodically accumulating the sample values of the discharging current (i.e., the measurement value of the cell current).

At this time, multiple rest periods may be provided while the first charge protocol or the first discharge protocol is in progress, and the open circuit voltages of the positive electrode and the negative electrode of the reference cell, respectively, measured at specific timings within each rest period, may be recorded as the positive electrode voltage and the negative electrode voltage of the reference cell.

When being compared with the open circuit voltage, the second charge protocol or the second discharge protocol may be utilized to obtain the closed circuit voltage of each of the positive electrode and the negative electrode of the reference cell. The second charge protocol may be a constant current charging method using the second current rate. The second discharge protocol may be a constant current discharging method using the second current rate. For example, while the reference cell is being continuously charged by the second charge protocol or while the reference cell is being continuously discharged by the second discharge protocol, the closed circuit voltages of the positive electrode and the negative electrode of the reference cell, which are measured periodically or non-periodically, may be recorded as the positive electrode voltage and the negative electrode voltage of the reference cell.

In this specification, the first electric stimulation refers to electric stimulation that causes a difference between OCV and CCV equal to or smaller than a reference value in the battery cell, and the second electric stimulation refers to electric stimulation that causes a difference between OCV and CCV greater than the reference value in the battery cell.

For example, the first electric stimulation may be charging using a first current rate, and the second electric stimulation may be charging using a second current rate greater than the first current rate.

As another example, the first electric stimulation may be discharging using a first current rate, and the second electric stimulation may be discharging using a second current rate greater than the first current rate.

Implementing the first charge protocol or the first discharge protocol may mean applying a first electric stimulation to the battery cell. Implementing the second charge protocol or the second discharge protocol may mean applying a second electric stimulation to the battery cell.

For convenience of explanation, it is assumed that the horizontal axis represents the charging capacity in FIGS. 2 to 9.

At least one of the reference positive electrode profile Rp and the reference negative electrode profile Rn may be aligned along the horizontal axis so that the synthesis result of a part of the common capacity range (5 to 50 Ah in FIG. 2) of the two profiles (Rp, Rn) matches the reference full-cell profile R. FIG. 2 shows an example in which the reference negative electrode profile Rn is aligned to be shifted to the right based on the start point (point corresponding to capacity 0) of the reference positive electrode profile Rp.

It may be found from FIG. 2 that both ends of the reference positive electrode profile Rp and the reference negative electrode profile Rn are offset from each other. In other words, the capacity range of the reference positive electrode profile Rp and the capacity range of the reference negative electrode profile Rn do not match and only partially overlap. Therefore, the reference full-cell profile R indicates the full-cell voltage of a reference cell in a part of the capacity range common to the reference positive electrode profile Rp and the reference negative electrode profile Rn. In other words, the reference full-cell profile R is an example of the full-cell voltage profile obtained by directly subtracting a part of the reference negative electrode profile Rn from a part of the reference positive electrode profile Rp.

The reference full-cell profile R may represent the correspondence between the capacity and the full-cell voltage of a new battery cell that is verified as a good product. In other words, the reference cell has the same level of positive electrode performance and negative electrode performance as the new battery cell that is verified as a good product. The positive electrode performance and the negative electrode performance of any battery cell may be collectively referred to

8

as the 'charge/discharge performance.'

The new battery cell refers to a battery cell in a new state. The new state is the same concept as BOL (Beginning Of Life). For example, it may be called BOL before the time when the cumulative charge/discharge capacity from the time of manufacturing completion reaches the set capacity, and it may be called MOL (Middle Of Life) from the time when the cumulative charge/discharge capacity reaches the set capacity.

The reference full-cell profile R may represent the correspondence between the voltage and capacity of the reference cell over at least the voltage range of interest (e.g., 3.0 to 4.0V). The lower and upper limits of the voltage range of interest may be the first set voltage (3.0V in FIG. 2) and the second set voltage (4.0V in FIG. 2).

If the full-cell voltage of any battery cell, including the reference cell, is equal to the first set voltage, SOC may be set to 0%. When the full-cell voltage of any battery cell, including the reference cell, is equal to the second set voltage, SOC may be set to 100%. According to FIG. 2, the reference cell may reach a full charge state (SOC 100%) from a full discharge state (SOC 0%) by a charging capacity of 45 Ah.

In this specification, the positive electrode participation start point on the positive electrode profile of any battery cell represents the positive electrode voltage and the positive electrode capacity (or positive electrode SOC) when the full-cell voltage of the corresponding battery cell matches the first set voltage. Also, the negative electrode participation start point on the negative electrode profile of the corresponding battery cell indicates the negative electrode voltage and the negative electrode capacity (or negative electrode SOC) when the full-cell voltage of the corresponding battery cell matches the first set voltage. Therefore, the voltage difference between the positive electrode participation start point and the negative electrode participation start point may be equal to the first set voltage.

In addition, the positive electrode participation end point on the positive electrode profile of any battery cell indicates the positive electrode voltage and the positive electrode capacity (or positive electrode SOC) when the full-cell voltage of the corresponding battery cell matches the second set voltage. Also, the negative electrode participation end point on the negative electrode profile of the corresponding battery cell indicates the negative electrode voltage and the negative electrode capacity (or negative electrode SOC) when the full-cell voltage of the corresponding battery cell matches the second set voltage. Therefore, the voltage difference between the positive electrode participation end point and the negative electrode participation end point may be equal to the second set voltage.

In this specification, the positive electrode capacity (capacity value) at a specific point on the positive electrode profile of any battery cell may mean the capacity difference between any one of both end points of the positive electrode profile and the specific point. The positive electrode SOC at a specific point on the positive electrode profile of any battery cell may mean the ratio of the capacity difference between any one of both end points (e.g., low capacity point) of the positive electrode profile and the specific point to the capacity difference between two end points of the positive electrode profile. The capacity difference between both end points of the positive electrode profile may be referred to as a total positive electrode capacity.

Likewise, the negative electrode capacity (capacity value) at a specific point on the negative electrode profile of any battery cell may mean the capacity difference between any one of both end points of the negative electrode profile (or positive electrode profile) and the specific point. The negative electrode SOC at a specific point on the negative electrode profile of any battery cell may mean the ratio of the capacity difference between any one of both end points (e.g., low capacity point) of the negative electrode profile (or positive electrode profile) and the specific point to the capacity difference between both end points of the negative electrode profile. The capacity difference between both end points of the negative electrode profile may be referred to as a total negative electrode capacity.

In the memory unit 330, the information indicating the voltage at each of the reference positive electrode participation start point (pi0), the reference positive electrode participation end point (pf0), the reference negative electrode participation start point (ni0), and the reference negative electrode participation end point (nf0) may be recorded in advance. The reference positive electrode participation start point (pi0) and the reference positive electrode participation end point (pf0) are the positive electrode participation start point and the positive electrode participation end point on the reference positive electrode profile Rp, respectively. The reference negative electrode participation start point (ni0) and the reference negative electrode participation end point (nf0) are the negative electrode participation start point and the negative electrode participation end point on the reference negative electrode profile Rn, respectively.

The voltage difference between the reference positive electrode participation start point (pi0) and the reference negative electrode participation start point (ni0) may be equal to the first set voltage (e.g., 3.0V). The voltage difference between the reference positive electrode participation end point (pf0) and the reference negative electrode participation end point (nf0) may be equal to the second set voltage (e.g., 4.0V).

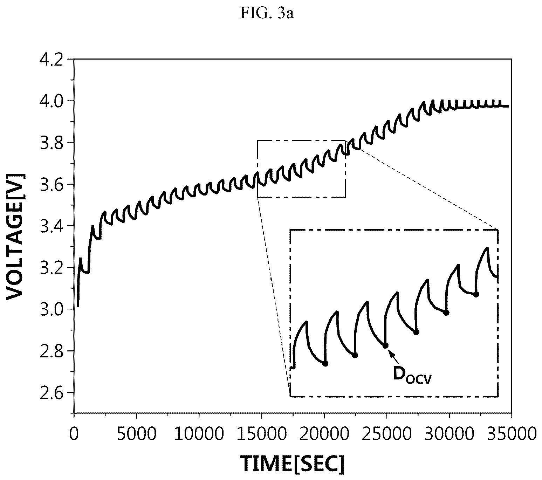

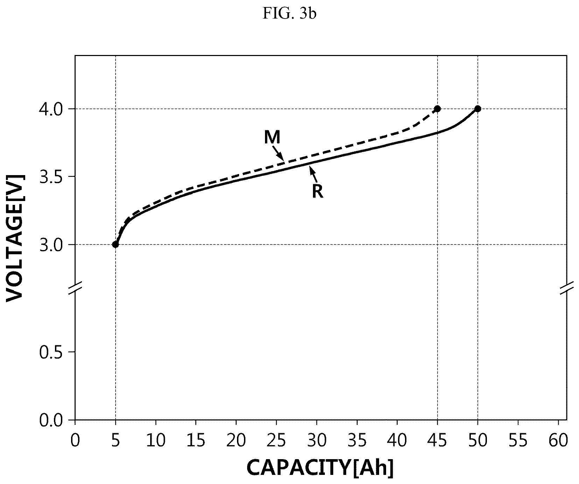

FIGS. 3a and 3b are graphs referenced to exemplarily describe the process of obtaining a measurement full-cell profile of a target cell.

The graph depicted in FIG. 3a shows an example of the change in full-cell voltage of the target cell over time due to intermittent application of the second electric stimulation. The target cell is a battery cell that is subject to diagnosis by the battery diagnosis apparatus. The target cell may be a new battery cell that requires verification as to whether it is a good product, or a battery cell that is no longer a new product due to degradation after being verified as a good product.

Hereinafter, the target cell is also designated by a reference sign BC.

Referring to FIG. 3a, the processor 320 may control the stimulation applying device 301 to intermittently apply the second electric stimulation greater than the first electric stimulation to the target cell BC.

The procedure for controlling the stimulation applying device 301 to diagnose the target cell BC may be carried out during the state change period until the electric state (e.g., full-cell voltage) of the target cell BC changes from the initial state (e.g., first set voltage) to the target state (e.g., second set voltage).

Referring to the graph in FIG. 3a, the full-cell voltage of the target cell BC has a rising trend while repeating a sawtooth-shaped form. Each sawtooth-shaped voltage rise segment is caused by the application of the second electric stimulation, and the voltage drop segment is caused by the interruption of the second electric stimulation. That is, the voltage drop segment represents the change in full-cell voltage of the target cell BC over each rest period.

During the state change period, the processor 320 may repeatedly record current measurement values of the target cell BC to generate current time series data.

The processor 320 may control the stimulation applying device 301 to initiate a rest period of the second electric stimulation whenever a predetermined rest condition is satisfied within the state change period. In other words, the procedure of applying the second electric stimulation may be temporarily stopped when the rest condition is satisfied. For example, at least one of (i) the current integration value changes by a threshold integration value, (ii) the SOC changes by a threshold SOC, and (iii) the time for which the application of the second electric stimulation is maintained reaches a threshold time may be preset as a rest condition. For example, if the total current integration value during the state change period is 40 Ah and the threshold integration value is 2 Ah, a total of 20 rest periods may be granted in the state change period.

The processor 320 may determine at least one of the threshold integration value, the threshold SOC, and the threshold time based on the full charge capacity of the target cell BC, the SOH, or the previous diagnosis result (e.g., the capacity value of the negative electrode participation end point, the negative electrode loss rate). At least one of the threshold integration value, the threshold SOC, and the threshold time may have a predetermined positive (or negative) correspondence with the full charge capacity, the SOH, or the previous diagnosis result, and the relationship data (data table for controlling the rest period) in which this correspondence is defined may be stored in advance in the memory unit 330. Due to the predetermined positive (or negative) correspondence, as the full charge capacity, the SOH, or the previous diagnosis result decreases, at least one of the threshold integration value, the threshold SOC, and the threshold time also decreases. As a result, as the target cell BC deteriorates over time, rest periods are applied at short time intervals within the state change period, so it is possible to prevent the number of data points included in the voltage time series data, which indicates the change history of the full-cell voltage over time during the rest periods of the state change period, from being reduced.

The processor 320 may obtain at least one of the threshold integration value, the threshold SOC, and the threshold time mapped to the full charge capacity, the SOH, or the previous diagnosis result from the data table for rest period control. The processor 320 may control the intermittent application procedure of the second electric stimulation over the state change period using at least one of the threshold integration value, the threshold SOC, and the threshold time obtained from the data table for rest period control.

The processor 320 may control the stimulation applying device 301 to resume application of the second electric stimulation when the reference time passes from the start time point of the rest period of the second electric stimulation. The reference time may be predetermined so that the polarization caused by the second electric stimulation may be sufficiently resolved. For example, the reference time, which is the length of time of the rest period, may be the time required for the polarization at the start time point of the rest period to become 10% or less.

In each rest period of the second electric stimulation, the full-cell voltage of the target cell BC is measured at least once. As an example, the processor 320 may record the measurement value of the full-cell voltage at the end time point of each rest period of the second electric stimulation as the OCV of the target cell BC. As another example, the full-cell voltage may be measured at least three times in each rest period of the second electric stimulation, and the processor 320 may estimate the OCV of the target cell BC for each rest period based on the three full-cell voltage measurement values for each rest period.

Accordingly, the voltage time series data may be generated by recording the OCV multiple times with time differences during the state change period. Each OCV point ($D_{OCV}$) marked in FIG. 3a is an example of a data point representing the voltage time series data.

The inventors of the present disclosure have recognized through multiple experiments that the voltage time series data generated in the above manner using the second electric stimulation has high consistency with the voltage time series data generated when actually applying the first electric stimulation to the target cell BC.

From now on, the advantages of a diagnostic method based on intermittent application of the second electric stimulation instead of continuous application of the first electric stimulation will be described.

It is assumes that the conditions related to the diagnosis of the target cell BC are as follows.

(i) First electric stimulation = charging at 0.05 C
(ii) Second electric stimulation = charging at 3.0 C
(iii) Length of the rest period of the second electric stimulation = 12 minutes
(iv) Total capacity change during the state change period = 80% of the full charge capacity (FCC) of the target cell BC.
(v) Threshold integration value = 3% of the full charge capacity of the target cell BC

Then, the time taken for the target cell BC to change from the initial state to the target state by continuously applying the first electric stimulation is 1/0.05*80% = 16 hours.

In comparison, the time taken for the charging capacity of the target cell BC to increase by the threshold integration value by the second electric stimulation is 0.03/3*80% = 0.008 hours. Also, since a rest period is granted whenever the charging capacity increases by 3%, a total of 26 rest periods are granted during the state change period. Therefore, the time taken for the target cell BC to change from the initial state to the target state by intermittent application of the second electric stimulation is (0.008 hours+0.2 hours)*26 = 5.4 hours.

In other words, compared to the method of continuously applying the first electric stimulation, the method of intermittently applying the second electric stimulation is advantageous in shortening the time for obtaining the full-cell profile.

In the graph of FIG. 3b, the horizontal axis (X-axis) represents capacity (Ah) and the vertical axis (Y-axis) represents voltage.

Referring to FIG. 3b, the processor 320 may generate a measurement full-cell profile M representing the correspondence between capacity and voltage (also referred to as 'full-cell voltage') of the target cell BC. The measurement full-cell profile may also be referred to as a Q-V profile or a Q-OCV profile.

Here, the full-cell voltage is the voltage across both ends of the target cell BC, and is distinguished from the positive electrode voltage and the negative electrode voltage described above. In other words, the full-cell voltage of the target cell BC may be regarded as the difference between the positive electrode voltage and the negative electrode voltage of the target cell BC.

To generate the measurement full-cell profile M, the current time series data and the voltage time series data mapped to the state change period may be used.

In detail, each data point of the current time series data and the voltage time series data is indexed in time order. Accordingly, the processor 320 may generate capacity time series data by sequentially integrating data points of the current time series data. In addition, the processor 320 may generate a measurement full-cell profile M by applying a curve fitting algorithm to a set of multiple Q-OCV pairs obtained by mapping between the capacity time series data and the voltage time series data. The reference full-cell profile R, the reference positive electrode profile Rp, the reference negative electrode profile Rn, and the measurement full-cell profile M may be a polynomial equation where the order of the highest term is predetermined.

Like the reference full-cell profile R, the measurement full-cell profile M may represent the correspondence between the capacity of the target cell BC over at least the voltage range of interest (e.g., 3.0 to 4.0V) and the OCV.

Since there is inevitably some difference in the charge/discharge performance between the reference cell and the target cell BC, there is also some difference between the measurement full-cell profile M and the reference full-cell profile R, as shown in FIG. 3b.

For example, at the same capacity value, the voltage of the measurement full-cell profile M is higher than the voltage of the reference full-cell profile R, which is caused by a manufacturing defect of the target cell BC, loss of the positive electrode capacity, loss of the negative electrode capacity, and/or loss of the available lithium. It is obvious that as the target cell BC degrades through repeated charge/discharge, the difference between the measurement full-cell profile M and the reference full-cell profile R will gradually increase. According to FIG. 3b, unlike the reference cell described with reference to FIG. 2, a charge capacity of 40 Ah is required for the full-cell voltage of the target cell BC to reach the second set voltage from the first set voltage, which is less than the charge capacity of 50 Ah of the reference cell by 5 Ah under the same conditions.

Meanwhile, in the graphs of FIGS. 2 and 3b, Ah is used as the unit on the horizontal axis, but this unit may be expressed in other forms. For example, the unit on the horizontal axis may be percentage %, which represents SOC (State Of Charge), instead of Ah.

When the measurement full-cell profile M is generated, the processor 320 may be configured to compare the measurement full-cell profile M with at least one comparison full-cell profile. Here, the comparison full-cell profile may be a result of generating an adjusted positive electrode profile and an adjusted negative electrode profile by adjusting each of the reference positive electrode profile Rp and the reference negative electrode profile Rn stored in the memory unit 330, and then synthesizing (combining) the adjusted positive electrode profile and the adjusted negative electrode profile.

In other words, when the reference full-cell profile R is the result of subtracting a part of the reference negative electrode profile Rn from a part of the reference positive electrode profile Rp, the comparison full-cell profile may be regarded as the result of subtracting a part of the adjusted negative electrode profile from a part of the adjusted positive electrode profile.

The processor 320 may generate at least one comparison full-cell profile by directly adjusting the reference positive electrode profile Rp and the reference negative electrode profile Rn. Alternatively, the at least one comparison full-cell profile may be secured in advance based on the reference positive electrode profile Rp and the reference negative electrode profile Rn and stored in the memory unit 330. In this case, the processor 320 may also obtain the comparison full-cell profile by accessing the memory unit 330 and reading the comparison full-cell profile.

The processor 320 may generate a plurality of comparison full-cell profiles from the reference positive electrode profile Rp and the reference negative electrode profile Rp by repeating an adjustment procedure of adjusting each of the reference positive electrode profile Rp and the reference negative electrode profile Rp to several levels and then synthesizing them. The comparison full-cell profile may also be referred to as an 'adjusted reference full-cell profile'.

The processor 320 may specify any one comparison full-cell profile among the plurality of comparison full-cell profiles, which has a minimum error with respect to the measurement full-cell profile M. Then, the processor 320 may determine that the adjusted positive electrode profile and the adjusted negative electrode profile mapped to the specified comparison full-cell profile are the positive electrode profile and the negative electrode profile of the target cell BC.

In relation to this, various methods known at the time of filing of this application may be employed to determine the error between two profiles, each of which may be expressed in a two-dimensional coordinate system. For example, the integral or the RMSE (Root Mean Square Error) of the absolute value of the area between the two profiles may be used as the error between the two profiles.

According to this configuration of the present disclosure, various state information about the target cell BC may be obtained based on the finally determined adjusted positive electrode profile and adjusted negative electrode profile. The finally determined adjusted positive electrode profile and adjusted negative electrode profile may be mapped to the comparison full-cell profile mapped with the minimum error. In particular, the comparison full-cell profile obtained by the finally determined adjusted positive electrode profile and adjusted negative electrode profile may be almost identical to the measurement full-cell profile M in shape, etc.

Therefore, according to the present disclosure, the positive electrode profile and the negative electrode profile for the target cell BC may be obtained even without disassembling the target cell BC or manufacturing it in the form of a 3-electrode battery.

If the target cell BC is the new battery cell, the adjusted positive electrode profile and the adjusted negative electrode profile may be analyzed and utilized more easily to diagnose whether a defect occurs in the target cell BC and, if so, what type of defect it is.

If a battery cell is used after the target cell BC is verified to be a good product, it is possible to determine how much the target cell BC is deteriorated for each degradation item through the adjusted positive electrode profile and the adjusted negative electrode profile.

Furthermore, according to an embodiment of the present disclosure, the positive electrode profile and the negative electrode profile of the target cell BC may be obtained in a simple manner. The present disclosure may be implemented even if only one reference positive electrode profile Rp and one reference negative electrode profile Rn are stored in the memory unit 330. That is, there is no need to store a plurality of reference positive electrode profiles Rp and/or a plurality of reference negative electrode profiles Rn in the memory unit 330. Accordingly, there is no need for the storage capacity of the memory unit 330 to be high, and there is no need to conduct a large number of preliminary tests required to secure a plurality of reference positive electrode profiles Rp and/or a plurality of reference negative electrode profiles Rn.

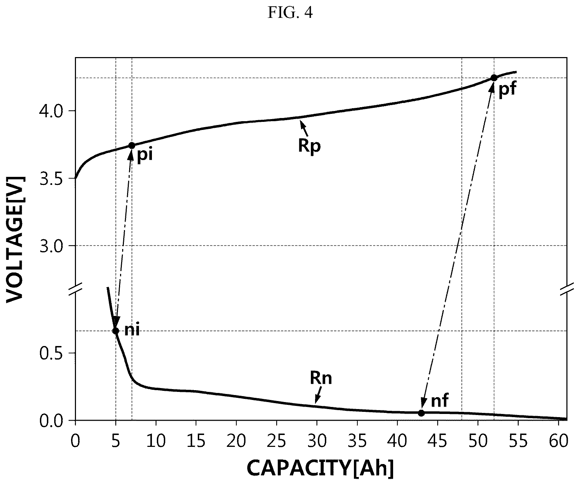

Hereinafter, referring to FIGS. 4 to 9, the process of analyzing the measurement full-cell profile M for estimating the negative electrode loading amount, which is one of the parameters involved in the current charge/discharge performance of the target cell BC, will be described. The negative electrode loading amount of any battery cell is a term indicating the amount of negative electrode active material per unit area of the negative electrode of the battery cell, and its unit may be mAh/cm$^2$ or mg/cm$^2$.

FIGS. 4 to 6 are diagrams referenced to describe an example of a procedure of generating a comparison full-cell profile used for comparison with the measurement full-cell profile according to an embodiment of the present disclosure.

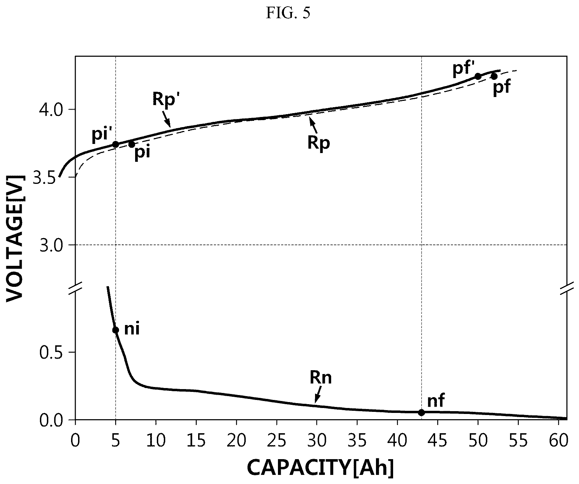

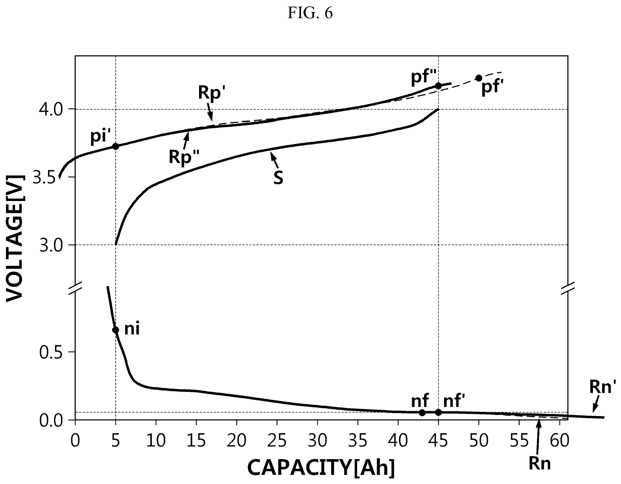

The procedure for generating a comparison full-cell profile, which will be explained with reference to FIGS. 4 to 6, proceeds in the order of a first routine for setting four points (positive electrode participation start point, positive electrode participation end point, negative electrode participation start point, negative electrode participation end point) to correspond to the voltage range of interest (see FIG. 4), a second routine for performing the profile shift (see FIG. 5), and a third routine for performing the capacity scaling (see FIG. 6). That is, the procedure for generating a comparison full-cell profile according to an embodiment of the present disclosure includes the first to third routines.

First, referring to FIG. 4, the reference positive electrode profile Rp and the reference negative electrode profile Rn are the same as those shown in FIG. 2.

The processor 320 determines the positive electrode participation start point (pi), the positive electrode participation end point (pf), the negative electrode participation start point (ni) and the negative electrode participation end point (nf) on the reference positive electrode profile Rp and the reference negative electrode profile Rn.

Either the positive electrode participation start point (pi) or the negative electrode participation start point (ni) depends on the other.

As an example, the processor 320 may divide the positive electrode voltage range from the start point to the end point (or, second set voltage) of the reference positive electrode profile Rp into a plurality of small voltage sections, and then set a boundary point of two adjacent small voltage sections among the plurality of small voltage sections as a positive electrode participation start point (pi). Each small voltage section may have a predetermined size (e.g., 0.01V). Next, the processor 320 may set a point on the reference negative electrode profile Rn that is smaller than the positive electrode participation start point (pi) by the first set voltage (e.g., 3V) as a negative electrode participation start point (ni).

As another example, the processor 320 may divide the negative electrode voltage range from the start point to the end point of the reference negative electrode profile Rn into a plurality of small voltage sections of a predetermined size, and then set a boundary point of two adjacent small voltage sections among the plurality of small voltage sections as a negative electrode participation start point (ni). Next, the processor 320 may search for a point greater than the negative electrode participation start point (ni) by the first set voltage from the reference positive electrode profile Rp and set the searched point as a positive electrode participation start point (pi).

Either the positive electrode participation end point (pf) or the negative electrode participation end point (nf) depends on the other.

As an example, the processor 320 may divide the voltage range from the second set voltage to the end point of the reference positive electrode profile Rp into a plurality of small voltage sections of a predetermined size, and then set a boundary point two adjacent small voltage section among the plurality of small voltage sections as a positive electrode participation end point (pf). Next, the processor 320 may set a point on the reference negative electrode profile Rn that is smaller than the positive electrode participation end point (pf) by the second set voltage (e.g., 4V) as a negative electrode participation end point (nf).

As another example, the processor 320 may divide the negative electrode voltage range from the start point to the end point of the reference negative electrode profile Rn into plurality of small voltage sections of a predetermined size, and then set a boundary point between two adjacent small voltage sections among the plurality of small voltage sections as a negative electrode participation end point (nf). Next, the processor 320 may search for a point that is greater than the negative electrode participation end point (nf) by the second set voltage from the reference positive electrode profile Rp and set the searched point as a positive electrode participation end point (pf).

If the positive electrode participation start point (pi), the positive electrode participation end point (pf), the negative electrode participation start point (ni), and the negative electrode participation end point (nf) are completely determined, the processor 320 shifts at least one of the reference positive electrode profile Rp and the reference negative electrode profile Rn to the left or right along the horizontal axis.

Referring to FIG. 5, the processor 320 may shift the reference positive electrode profile Rp to the left (toward low capacity) or shift the reference negative electrode profile Rn to the right (toward high capacity), or shift both of them, so that the capacity values of the positive electrode participation start point (pi) and the negative electrode participation start point (ni) match.

Alternatively, the processor 320 shifts the reference positive electrode profile Rp to the left or shift the reference negative electrode profile Rn to the right, or shift both of them, so that the capacity values of the positive electrode participation end point (pf) and the negative electrode participation end point (nf) match.

FIG. 5 illustrates a situation where only the reference positive electrode profile Rp is shifted to the left to generate an adjusted reference positive electrode profile (Rp'), and as a result, the capacity value of the positive electrode participation start point (pi') matches the capacity value of the negative electrode participation start point (ni). The adjusted reference positive electrode profile (Rp') is the result of applying an adjustment procedure that shifts to the left by the voltage difference between the positive electrode participation start point (pi) and the negative electrode participation start point (ni) to the reference positive electrode profile Rp. Therefore, the two points (pi, pi') are different only in capacity value and have the same voltage. The two points (pf, pf') are also different only in the capacity value and have the same voltage.

If the adjustment result profiles (Rp', Rn) in which at least one of the reference positive electrode profile Rp and the reference negative electrode profile Rn is shifted are secured, the processor 320 scales the capacity range of at least one of the adjustment result profiles (Rp', Rn).

According to the example shown in FIG. 5, the processor 320 performs an additional adjustment procedure to shrink or expand at least one of the adjusted reference positive electrode profile (Rp') and the reference negative electrode profile Rn along the horizontal axis.

Referring to FIG. 6, the processor 320 may generate an adjusted reference positive electrode profile (Rp") by shrinking or expanding the adjusted reference positive electrode profile (Rp') so that the size of the capacity range between two points (pi', pf') of the adjusted reference positive electrode profile (Rp') matches the size of the capacity range of the measurement full-cell profile M. At this time, any one point (pi') of the two points (pi', pf') may be fixed. Accordingly, the capacity difference between the two points (pi', pf") of the adjusted reference positive electrode profile (Rp") may match the capacity range of the measurement full-cell profile M.

In addition, the processor 320 may generate an adjusted reference negative electrode profile (Rn') by shrinking or expanding the reference negative electrode profile Rn so that the size of the capacity range between two points (ni, nf) of the reference positive electrode profile Rn matches the size of the capacity range of the measurement full-cell profile M. At this time, any one point (ni) of the two points (ni, nf) may be fixed. Accordingly, the capacity difference between the two points (ni, nf') of the adjusted reference negative electrode profile (Rn') may match the capacity range of the measurement full-cell profile M.

In FIG. 6, the adjusted reference positive electrode profile (Rp") is the result of shrinking the adjusted reference positive electrode profile (Rp') shown in FIG. 5, and the adjusted reference negative electrode profile (Rn') is the result of expanding the reference negative electrode profile Rn shown in FIG. 5.

The positive electrode participation end point (pf") on the adjusted reference positive electrode profile (Rp") corresponds to the positive electrode participation end point (pf) on the adjusted reference positive electrode profile (Rp'). The negative electrode participation end point (nf') on the adjusted reference negative electrode profile (Rn') corresponds to the negative electrode participation end point (nf) on the reference negative electrode profile Rn.

The capacity difference between the positive electrode participation start point (pi') and the positive electrode participation end point (pf") of the adjusted reference positive electrode profile (Rp") corresponds to the size of the capacity range of the measurement full-cell profile M. Likewise, the capacity difference between the negative electrode participation start point (ni) and the negative electrode participation end point (nf') of the adjusted reference negative electrode profile (Rn') corresponds to the size of the capacity range of the measurement full-cell profile M.

In addition, the capacity range by the two points (pi', pf') of the adjusted reference positive electrode profile (Rp") matches the capacity range by the two points (ni, nf') of the adjusted reference negative electrode profile (Rn'). The processor 320 may generate a comparison full-cell profile S by subtracting the profile between two points (pi, pf') of the adjusted reference positive electrode profile (Rp") from the profile between two points (ni, nf') of the adjusted reference negative electrode profile (Rn').

The processor 320 may calculate an error (profile error) between the comparison value between the comparison full-cell profile S and the measurement full-cell profile M.

The processor 320 may map at least two of the adjusted reference positive electrode profile (Rp"), the adjusted reference negative electrode profile (Rn'), the positive electrode participation start point (pi'), the positive electrode participation end point (pf"), the negative electrode participation start point (ni), the negative electrode participation end point (nf'), the positive electrode scale factor, the negative electrode scale factor, the comparison full-cell profile S, and the profile error with each other and record the same in the memory unit 330.

The positive electrode scale factor may represent the ratio of the capacity difference between both ends of the adjusted reference positive electrode profile (Rp") to the capacity difference between both ends of the reference positive electrode profile Rp. Alternatively, the positive electrode scale factor may represent the ratio of the capacity difference between two points (pi', pf') to the capacity difference between two points (pi0, pf0). Alternatively, the positive electrode scale factor may represent the ratio of the positive electrode capacity difference between two points (pi', pf') to the positive electrode capacity difference between two points (pi0, pf0). Alternatively, the positive electrode scale factor may represent the ratio of the positive electrode SOC difference between two points (pi', pf") to the positive electrode SOC difference between two points (pi0, pf0).

The negative electrode scale factor may represent the ratio of the capacity difference between both ends of the adjusted reference negative electrode profile (Rn') to the capacity difference between both ends of the reference negative electrode profile Rn. Alternatively, the negative electrode scale factor may represent the ratio of the capacity difference between two points (ni, nf') to the capacity difference between two points (ni0, nf0). Alternatively, the negative electrode scale factor may represent the ratio of the negative electrode capacity difference between two points (ni, nf') to the negative electrode capacity difference between two points (ni0, nf0). Alternatively, the negative electrode scale factor may represent the ratio of the negative electrode SOC difference between two points (ni, nf') to the negative electrode SOC difference between two points (ni0, nf0).

Meanwhile, as described above, when the positive electrode voltage range of the reference positive electrode profile Rp is divided into a plurality of small voltage sections, the boundary point of two adjacent small voltage sections among the plurality of small voltage sections may be set as a positive electrode participation start point (pi).

For example, if the positive electrode voltage range of the reference positive electrode profile Rp is divided into 100 small voltage ranges, there may be 100 boundary points that can be set as the positive electrode participation start point (pi). Also, if the voltage range greater than or equal to the second set voltage in the reference positive electrode profile Rp is divided into 40 small voltage ranges, there may be 40 boundary points that can be set as the positive electrode participation end point (pf). In this case, at least 4,000 different comparison full-cell profiles may be generated.

Of course, it will be easily understood by those skilled in the art that as the size of the small voltage section decreases, the maximum number of comparison full-cell profiles that can be generated increases, and conversely, as the size of the small voltage section increases, the maximum number of comparison full-cell profiles that can be generated decreases.

The processor 320 may identify a minimum value among profile errors of the plurality of comparison full-cell profiles generated as described above, and then obtain information mapped to the minimum profile error (e.g., at least one of a positive electrode participation start point, a positive electrode participation end point, a negative electrode participation start point, a negative electrode participation end point, a positive electrode scale factor, and a negative electrode scale factor) from the memory unit 330.

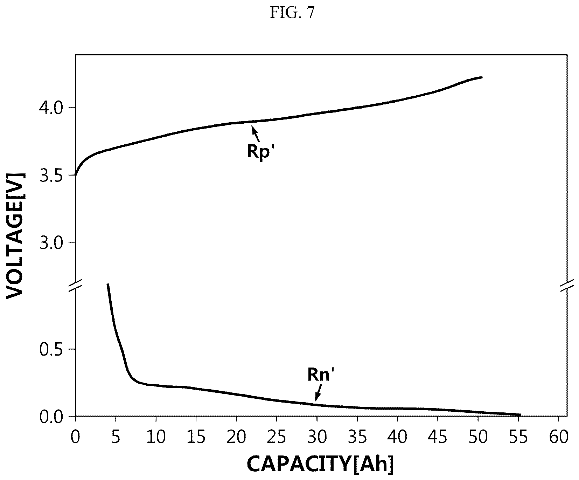

FIGS. 7 to 9 are diagrams referenced to describe another example of a procedure of generating a comparison full-cell profile used for comparison with the measurement full-cell profile according to an embodiment of the present disclosure. For reference, the embodiment shown in FIGS. 7 to 9 is independent from the embodiment shown in FIGS. 4 to 6. Accordingly, terms or reference signs commonly used to describe the embodiment shown in FIGS. 4 to 6 and the embodiment shown in FIGS. 7 to 9 should be understood as being limited to each embodiment.

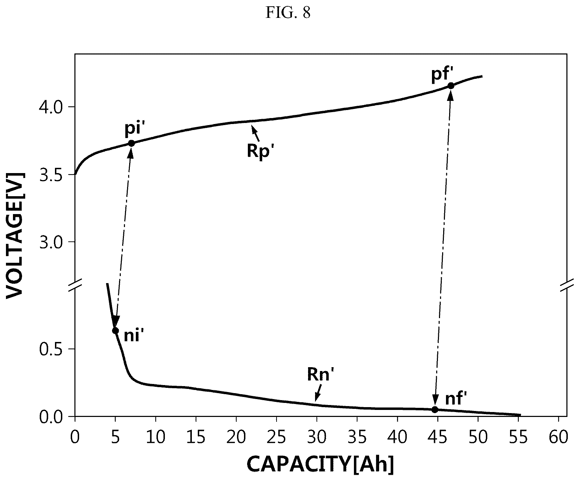

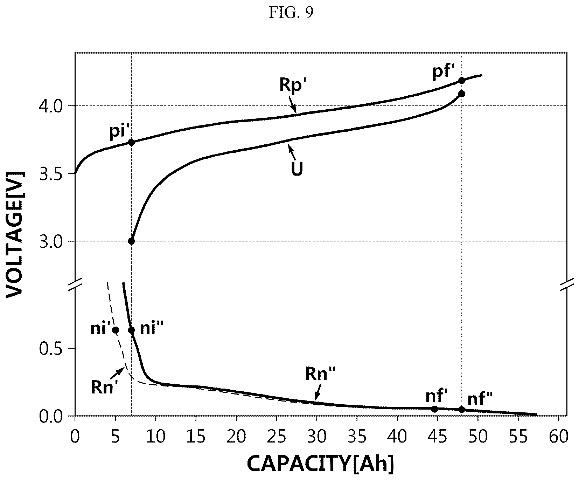

The procedure of generating a comparison full-cell profile to be explained with reference to FIGS. 7 to 9 proceeds in the order of a fourth routine (see FIG. 7) that performs the capacity scaling, a fifth routine (see FIG. 8) that sets four points (positive electrode participation start point, positive electrode participation end point, negative electrode participation start point, and negative electrode participation end point), and a sixth routine (see FIG. 9) that performs the profile shift. That is, the procedure of generating a comparison full-cell profile according to another embodiment of the present disclosure includes the fourth to sixth routines.

Referring to FIG. 7, the processor 320 generates an adjusted reference positive electrode profile (Rp') and an adjusted reference negative electrode profile (Rn') by applying the positive electrode scale factor and the negative electrode scale factor selected from the scaling value range to the reference positive electrode profile Rp and the reference negative electrode profile (Rn), respectively.

The scaling value range may be predetermined or may vary depending on the ratio of the size of the capacity range of the measurement full-cell profile M to the size of the capacity range of the reference full-cell profile (R). As an example, assuming that the positive electrode scale factor and the negative electrode scale factor can be selected among the values (i.e., 90%, 90.1%, 90.2%, ... 98.9%, 99%) spaced by 0.1% in the scaling value range (e.g., 90 to 99%), 91 values may be selected as the positive electrode scale factor and the negative electrode scale factor, respectively. In this case, according to $91 \times 91 = 8,281$ adjustment levels (combinations of the positive electrode scale factors and the negative electrode scale factors), a maximum of 8,281 adjusted profile pairs may be generated. The adjusted profile pair refers to a combination of an adjusted positive electrode profile and an adjusted negative electrode profile.

Referring to FIG. 7, the adjusted reference positive electrode profile (Rp') and the adjusted reference negative electrode profile (Rn') illustrate the result of applying the positive electrode scale factor and the negative electrode scale factor, respectively, to the reference positive electrode profile Rp and the reference negative electrode profile Rn.

Since the positive electrode scale factor and the negative electrode scale factor are less than 100%, the adjusted reference positive electrode profile (Rp') is obtained by shrinking the reference positive electrode profile Rp along the horizontal axis, and the adjusted reference negative electrode profile (Rn') is also obtained by shrinking the reference negative electrode profile Rn along the horizontal axis. To facilitate understanding, the reference positive electrode profile Rp and the reference negative electrode profile Rn are shown in a form in which the start points of them are respectively fixed and the remaining parts are shrunken to the left along the horizontal axis.

Referring to FIG. 8, the processor 320 determines a positive electrode participation start point (pi'), a positive electrode participation end point (pf'), a negative electrode participation start point (ni'), and a negative electrode participation end point (nf') on the adjusted reference positive electrode profile (Rp') and the adjusted reference negative electrode profile (Rp').

Either the positive electrode participation start point (pi') or the negative electrode participation start point (ni') may depend on the other. Also, either the positive electrode participation end point (pf') or the negative electrode participation end point (nf') may depend on the other. Also, either the positive electrode participation start point (pi') or the positive electrode participation end point (pf') may be set based on the other.

That is, if any one of the positive electrode participation start point (pi'), the positive electrode participation end point (pf'), the negative electrode participation start point (ni'), and the negative electrode participation end point (nf') is set, the remaining three points may be automatically set by the first set voltage, the second set voltage, and/or the size of the capacity range of the measurement full-cell profile M (e.g., 45Ah - 5Ah = 40Ah in FIG. 3b).

As an example, the processor 320 may divide the positive electrode voltage range from the start point to the end point (or, second set voltage) of the adjusted reference positive electrode profile (Rp') into a plurality of small voltage sections, and then set a boundary point of two adjacent small voltage sections among the plurality of small voltage sections as the positive electrode participation start point (pi'). Next, the processor 320 may set a point on the adjusted reference negative electrode profile Rn that is smaller than the positive electrode participation start point (pi') by the first set voltage (e.g., 3V) as the negative electrode participation start point (ni').

As another example, the processor 320 may divide the negative electrode voltage range from the start point to the end point of the adjusted reference negative electrode profile (Rn') into a plurality of small voltage sections of a predetermined size, and then set a boundary point of two adjacent small voltage sections among the plurality of small voltage sections as the negative electrode participation start point (ni'). Next, the processor 320 may search for a point greater than the negative electrode participation start point (ni') by the first set voltage from the reference positive electrode profile Rp, and select the searched point as the positive electrode participation start point (pi').

As still another example, the processor 320 may divide the voltage range from the second set voltage to the end point of the adjusted reference positive electrode profile (Rp') into a plurality of small voltage sections of a predetermined size, and then set a boundary point of two adjacent small voltage sections among the plurality of small voltage sections as the positive electrode participation end point (pf'). Next, the processor 320 may search for a point smaller than the positive electrode participation end point (pf') by the second set voltage (e.g., 4V) from the adjusted reference negative electrode profile (Rn'), and set the searched point as the negative electrode participation end point (nf').

As still another example, the processor 320 may divide the negative electrode voltage range from the start point to the end point of the adjusted reference negative electrode profile (Rn') into a plurality of small voltage section of a predetermined size, and then set a boundary point of two adjacent small voltage sections among the plurality of small voltage sections as the negative electrode participation end point (nf'). Next, the processor 320 may search for a point greater than the negative electrode participation end point (nf') by the second set voltage from the adjusted reference positive electrode profile (Rp'), and set the searched point as the positive electrode participation end point (pf').

If any one of the positive electrode participation start point (pi'), the positive electrode participation end point (pf'), the negative electrode participation start point (ni'), and the negative electrode participation end point (nf') is determined, the processor 320 may additionally determine the remaining three points based on the determined point.

For example, if the positive electrode participation start point (pi') is determined first, the processor 320 may set a point on the adjusted reference positive electrode profile (Rp') having a capacity value that is larger than the capacity value of the positive electrode participation start point (pi') by the size of the capacity range of the measurement full-cell profile M as the positive electrode participation end point (pf'). In addition, the processor 320 may search for a point lower than the positive electrode participation start point (pi') by the first set voltage from the adjusted reference negative electrode profile (Rn'), and set the searched point as the negative electrode participation start point (ni'). In addition, the processor 320 may set a point on the adjusted reference negative electrode profile (Rn') having a capacity value greater than the capacity value of the negative electrode participation start point (ni') by the size of the capacity range of the measurement full-cell profile M as the negative electrode participation end point (nf').

As another example, when the positive electrode participation end point (pf') is determined first, the processor 320 may set a point on the adjusted reference positive electrode profile (Rp') having a capacity value smaller than the capacity value of the positive electrode participation end point (pf') by the size of the capacity range of the measurement full-cell profile M as the positive electrode participation start point (pi'). In addition, the processor 320 may search for a point lower than the positive electrode participation end point (pf') by the second set voltage from the adjusted reference negative electrode profile (Rn'), and set the searched point as the negative electrode participation end point (nf'). In addition, the processor 320 may set a point on the adjusted reference negative electrode profile (Rn') having a capacity value smaller than the capacity value of the negative electrode participation end point (nf') by the size of the capacity range of the measurement full-cell profile M as the negative electrode participation start point (ni').

As still another example, when the negative electrode participation start point (ni') is determined, the processor 320 may set a point on the adjusted reference negative electrode profile (Rn') having a capacity value larger than the capacity value of the negative electrode participation start point (ni') by the size of the capacity range of the measurement full-cell profile M as the negative electrode participation end point (nf'). In addition, the processor 320 may search for a point higher than the negative electrode participation start point (ni') by the first set voltage from the adjusted reference positive electrode profile (Rp'), and set the searched point as the positive electrode participation start point (pi'). In addition, the processor 320 may set a point on the adjusted reference positive electrode profile (Rp') having a capacity value greater than the capacity value of the positive electrode participation start point (pi') by the size of the capacity range of the measurement full-cell profile M as the positive electrode participation end point (pf').

As still another example, when the negative electrode participation end point (nf') is determined, the processor 320 may set a point on the adjusted reference negative electrode profile (Rn') having a capacity value smaller than the capacity value of the negative electrode participation end point (nf') by the size of the capacity range of the measurement full-cell profile M as the negative electrode participation start point (ni'). In addition, the processor 320 may search for a point higher than the negative electrode participation end point (nf') by the second set voltage from the adjusted reference positive electrode profile (Rp'), and set the searched point as the positive electrode participation end point (pf'). In addition, the processor 320 may set a point on the adjusted reference positive electrode profile (Rp') having a capacity value smaller than the capacity value of the positive electrode participation end point (pf') by the size of the capacity range of the measurement full-cell profile M as the positive electrode participation start point (pi').

If the positive electrode participation start point (pi'), the positive electrode participation end point (pf'), the negative electrode participation start point (ni') and the negative electrode participation end point (nf') are completely determined based on the pair of positive electrode scale factor and negative electrode scale factor, the processor 320 may shift at least one of the adjusted reference positive electrode profile (Rp') and the adjusted reference negative electrode profile (Rn') to the left or right along the horizontal axis so that the capacity values of the positive electrode participation start point (pi') and the negative electrode participation start point (ni') match or the capacity values of the positive electrode participation start point (pf') and the negative electrode participation start point (nf') match.

The adjusted reference negative electrode profile (Rn") shown in FIG. 9 is obtained by shifting only the adjusted reference negative electrode profile (Rn') shown in FIG. 8 to the right. Accordingly, the capacity values of the positive electrode participation start point (pi') and the negative electrode participation start point (ni") match each other on the horizontal axis. Relatedly, the capacity difference between the positive electrode participation start point (pi') and the positive electrode participation end point (pf') is equal to the capacity difference between the negative electrode participation start point (ni') and the negative electrode participation end point (nf'). Therefore, if the capacity values of the positive electrode participation start point (pi') and the negative electrode participation start point (ni") match each other, the capacity values of the positive electrode participation end point (pf') and the negative electrode participation end point (nf') also match each other on the horizontal axis.

Referring to FIG. 9, the processor 320 may generate a comparison full-cell profile U by subtracting the partial profile between two points (pi', pf') of the adjusted reference positive electrode profile (Rp') from the partial profile between two points (ni", nf") of the adjusted reference negative electrode profile (Rn").

The processor 320 may calculate an error (profile error) between the comparison full-cell profile U and the measurement full-cell profile M.

The processor 320 may map at least two of the adjusted reference positive electrode profile (Rp'), the adjusted reference negative electrode profile (Rn"), the positive electrode participation start point (pi'), the positive electrode participation end point (pf'), the negative electrode participation start point (ni"), the negative electrode participation end point (nf"), the positive electrode scale factor, the negative electrode scale factor, the comparison full-cell profile U and the profile error with each other and record the same in the memory unit 330.

As described above, the processor 320 may generate a comparison full-cell profile corresponding to each pair of the positive electrode scale factor and the negative electrode scale factor selected from the scaling value range. Since the pairs of positive electrode scale factor and negative electrode scale factor are plural, it is obvious that the comparison profile will also be generated in plural numbers. The processor 320 may identify a minimum value among profile errors of the plurality of comparison full-cell profiles, and then obtain information mapped to the minimum profile error from the memory unit 330.

The processor 320 may determine the negative electrode loading amount of the target cell BC from the information mapped to the minimum profile error. The processor 320 may estimate the negative electrode loading amount of the target cell BC based on the extracted negative electrode scale factor. For reference, at least one of the positive electrode participation start point, the positive electrode participation end point, the negative electrode participation start point, the negative electrode participation end point, the positive electrode scale factor, and the negative electrode scale factor when the target cell BC is in the new state may be already recorded in the memory unit 330 by executing the aforementioned analysis process when the target cell BC is in the new state.

The processor 320 may determine at least one degradation parameter (e.g., negative electrode loading amount) based on the information mapped to the minimum profile error. Table 1 below summarizes degradation parameters and formulas that may be used to determine each degradation parameter.

Table 1

| Degradation parameter | Formula |
|---|---|
| $P_{SOH}$ | $1 - \dfrac{pf_{BOL}-pf_{MOL}}{pf_{BOL}-pi_{BOL}}, \quad \dfrac{pf_{MOL}-pi_{BOL}}{pf_{BOL}-pi_{BOL}}, \quad 1 - \dfrac{pf_{BOL}-pf_{MOL}}{nf_{BOL}-ni_{BOL}}, \quad \dfrac{ps_{MOL}}{ps_{BOL}}$ |
| $N_{SOH}$ | $\dfrac{ns_{MOL}}{ns_{BOL}}$ |
| $L_{SOH}$ | $1 - \dfrac{pi_{MOL}-pi_{BOL}}{pf_{BOL}-pi_{BOL}}, \quad \dfrac{pf_{BOL}-pi_{MOL}}{pf_{BOL}-pi_{BOL}}, \quad 1 - \dfrac{pi_{MOL}-pi_{BOL}}{nf_{BOL}-ni_{BOL}}$ |
| $F_{SOH}$ | $\dfrac{pf_{MOL}-pi_{MOL}}{pf_{BOL}-pi_{BOL}}, \quad \dfrac{nf_{MOL}-ni_{MOL}}{nf_{BOL}-ni_{BOL}}$ |
| $P_{LOSS}$ | $\dfrac{pf_{BOL}-pf_{MOL}}{pf_{BOL}-pi_{BOL}}, \quad \dfrac{pf_{BOL}-pf_{MOL}}{nf_{BOL}-ni_{BOL}}, \quad 1 - \dfrac{ps_{MOL}}{ps_{BOL}}$ |

(continued)

| Degradation parameter | Formula |
|---|---|
| $N_{LOSS}$ | $$1 - \frac{ns_{MOL}}{ns_{BOL}}$$ |
| $L_{LOSS}$ | $$\frac{pi_{MOL}-pi_{BOL}}{pf_{BOL}-pi_{BOL}}, \quad \frac{pi_{MOL}-pi_{BOL}}{nf_{BOL}-ni_{BOL}}$$ |
| $F_{LOSS}$ | $$1 - \frac{pf_{MOL}-pi_{MOL}}{pf_{BOL}-pi_{BOL}}, \quad 1 - \frac{nf_{MOL}-ni_{MOL}}{nf_{BOL}-ni_{BOL}}, \quad \frac{(pf_{BOL}-pi_{BOL})-(pf_{MOL}-pi_{MOL})}{nf_{BOL}-ni_{BOL}}$$ |
| $P_{loading\_MOL}$ | $ps_{MOL} \times P_{loading\_ref}$ |
| $N_{loading\_MOL}$ | $ns_{MOL} \times N_{loading\_ref}$ |

Each of the variables listed in Table 1 is a diagnostic factor that may be determined by the analyzing process described above. The definitions of the degradation parameters and variables in Table 1 may be as follows. <Degradation parameters >

$P_{SOH}$: positive electrode SOH (State Of Health) of the target cell BC
$N_{SOH}$: negative electrode SOH of the target cell BC
$L_{SOH}$: available lithium SOH of the target cell BC
$F_{SOH}$: full-cell SOH of the target cell BC
$P_{LOSS}$: positive electrode loss rate of the target cell BC
$N_{LOSS}$: negative electrode loss rate of the target cell BC
$L_{LOSS}$: available lithium loss rate of the target cell BC
$F_{LOSS}$: full-cell loss rate of the target cell BC
$P_{loading\_MOL}$: positive electrode loading amount of the target cell BC
$N_{loading\_MOL}$: negative electrode loading amount of the target cell BC

The positive electrode loading amount of any battery cell represents the amount of positive electrode active material (or available capacity) per unit area of the positive electrode of the battery cell. The negative electrode loading amount of any battery cell represents the amount of negative electrode active material (or available capacity) per unit area of the negative electrode of the battery cell. The unit of the loading amount may be mAh/cm$^2$ or mg/cm$^2$. In Table 1, $P_{loading\_ref}$ represents the reference positive electrode loading amount, and $N_{loading\_ref}$ represents the reference negative electrode loading amount. The reference positive electrode loading amount is a predetermined value representing the amount of positive electrode active material (or available capacity) per unit area of the positive electrode of the reference cell. The reference positive electrode loading amount may be a value obtained by dividing the reference positive electrode capacity by the reference positive electrode area. Here, the reference positive electrode capacity may be a value preset as the total positive electrode capacity of the reference cell. The reference positive electrode area may be a value preset as the area of the positive electrode of the reference cell. The reference negative electrode loading amount is a predetermined value representing the amount of negative electrode active material (or available capacity) per unit area of the negative electrode of the reference cell. The reference negative electrode loading amount may be a value obtained by dividing the reference negative electrode capacity by the reference negative electrode area. Here, the reference negative electrode capacity may be a value preset as the total negative electrode capacity of the reference cell. The reference negative electrode area may be a value preset as the area of the negative electrode of the reference cell.

<Variables>

$pi_{BOL}$: positive electrode capacity (positive electrode SOC) of the positive electrode participation start point when the target cell BC is in the BOL state
$pi_{MOL}$: positive electrode capacity (positive electrode SOC) of the current positive electrode participation start point (e.g., pi' shown in FIG. 6) of the target cell BC
$pf_{BOL}$: positive electrode capacity (positive electrode SOC) of the positive electrode participation end point when the target cell BC is in the BOL state

$pf_{MOL}$: positive electrode capacity (positive electrode SOC) of the current positive electrode participation end point (e.g., pf" shown in FIG. 6) of the target cell BC

$ni_{BOL}$: negative electrode capacity (negative electrode SOC) at the negative electrode participation start point when the target cell BC is in the BOL state

$ni_{MOL}$: negative electrode capacity (negative electrode SOC) of the current negative electrode participation start point (e.g., ni shown in FIG. 6) of the target cell BC

$nf_{BOL}$: negative electrode capacity (negative electrode SOC) of the negative electrode participation end point when the target cell BC is in the BOL state

$nf_{MOL}$: negative electrode capacity (negative electrode SOC) of the current negative electrode participation end point (e.g., nf' shown in FIG. 6) of the target cell BC

$ps_{BOL}$: positive electrode scale factor when the target cell BC is in the BOL state

$ps_{MOL}$: current positive electrode scale factor of the target cell BC

$ns_{BOL}$: negative electrode scale factor when the target cell BC is in the BOL state

$ns_{MOL}$: current negative electrode scale factor of the target cell BC

The process of determining a diagnostic factor for the target cell BC may be repeated periodically or aperiodically throughout the life of the target cell BC.

The processor 320 may limit at least one of an allowable voltage range and an allowable SOC range for the target cell BC based on an estimation value of the negative electrode loading amount of the target cell BC. Relationship data indicating a predetermined positive correlation between a decrease amount of the negative electrode loading amount from the BOL state and the limit level may be stored in advance in the memory unit 330. That is, according to the relationship data, a decrease in the negative electrode loading amount causes a reduction of at least one of the allowable voltage range and the allowable SOC range. Reducing a range means at least one of increasing a lower limit of the range and decreasing an upper limit of the range.

For example, it is assumed that the allowable voltage range and the allowable SOC range are 2.5V to 4.5V and 5% to 95%, respectively. If the current negative electrode loading amount $N_{loading\_MOL}$ is estimated to be 90% of the value $N_{loading\_BOL}$ in the BOL state, the allowable voltage range may be reduced to 2.75V to 4.05V, and the allowable SOC range may be reduced to 5.5% to 85.5%.

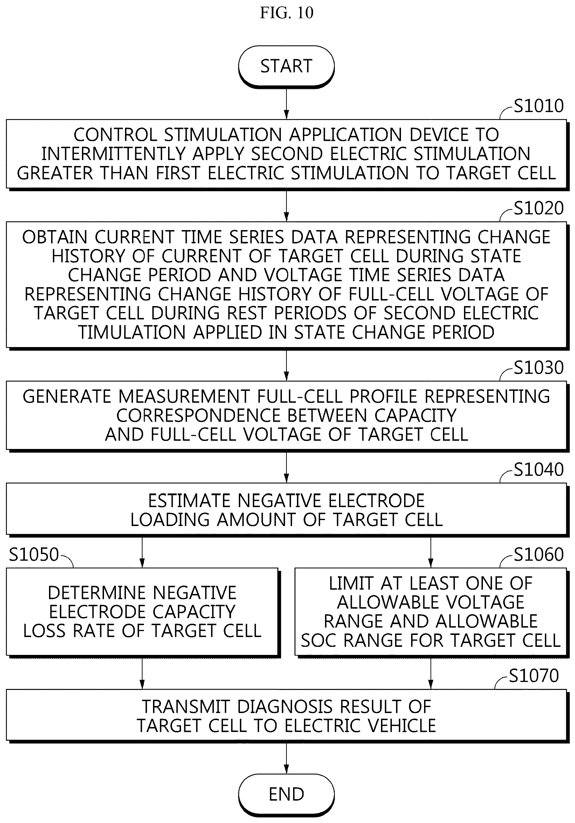

FIG. 10 is a flowchart referenced to exemplarily describe battery diagnosis method according to the first embodiment of the present disclosure. The method according to FIG. 10 may be performed by the battery diagnosis apparatus.

At Step S1010, the processor 320 controls the stimulation application device 301 to intermittently apply a second electric stimulation greater than the first electric stimulation to the target cell BC during a state change period until the electrical state of the target cell BC changes from an initial state to a target state.

In Step S1020, the processor 320 obtains current time series data representing a change history of the current of the target cell BC during the state change period and voltage time series data representing a change history of the full-cell voltage of the target cell BC during the rest periods of the second electric stimulation applied in the state change period using the communication unit 310. The voltage time series data may include a measurement value (see $D_{OCV}$ of FIG. 3a) of the full-cell voltage at the end time point of each rest period.

The communication unit 310 may collect current time series data and voltage time series data generated by the electric vehicle 1 from the electric vehicle 1 after the end of the state change period.

Alternatively, the communication unit 310 may periodically collect measurement data representing at least one measurement value of the current and the full-cell voltage of the target cell BC from the electric vehicle 1 during the state change period. In this case, each measurement value collected multiple times during the state change period may be recorded in time sequence in the memory unit 330. The processor 320 may generate current time series data and voltage time series data from the set of measurement values collected during the state change period.

In Step S1030, the processor 320 generates a measurement full-cell profile (see M in FIG. 3b) indicating a correspondence between the capacity and the full-cell voltage of the target cell BC based on the current time series data and the voltage time series data.

In Step S1040, the processor 320 analyzes the measurement full-cell profile to estimate the negative electrode loading amount of the target cell BC. The negative electrode loading amount represents the amount of negative electrode active material per unit area of the negative electrode.

In Step S1050, the processor 320 determines a negative electrode loss rate (which may also be referred to as a 'negative electrode capacity loss rate') of the target cell BC based on the estimation value of the negative electrode loading amount.

In Step S1060, the processor 320 limits at least one of an allowable voltage range and an allowable SOC range for the target cell BC based on the estimation value of the negative electrode loading amount. Alternatively or instead, the allowable current for the target cell BC may be limited (down-regulated).

In the method according to FIG. 10, only one of Steps S1050 and S1060 may be executed.

In Step S1070, the processor 320 may transmit the diagnosis result of the target cell BC to the electric vehicle 1 using the communication unit 310. The diagnosis result includes at least one of the negative electrode loading amount, the negative electrode loss rate, the limited allowable voltage range, and the limited allowable SOC range.

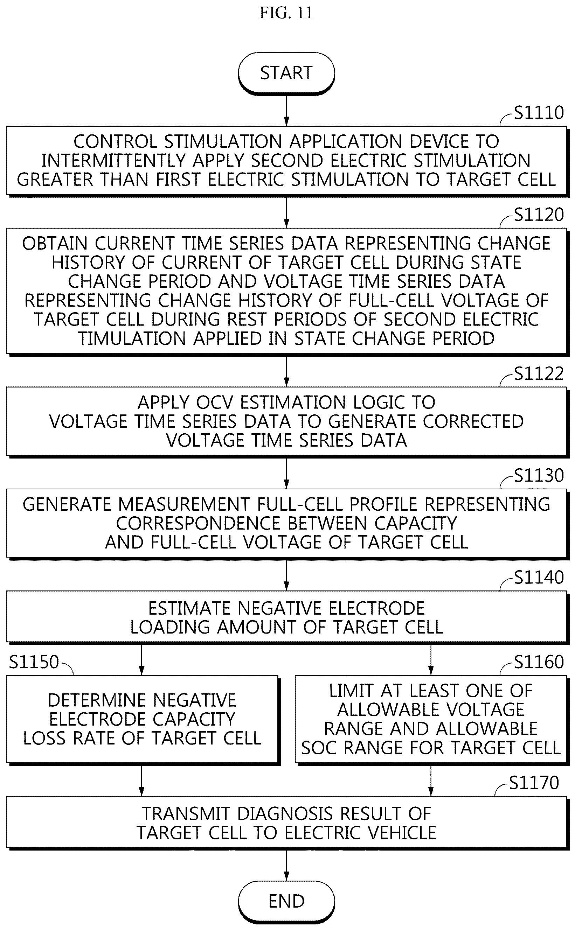

FIG. 11 is a flowchart referenced to exemplarily describe a battery diagnosis method according to the second embodiment of the present disclosure. The method according to FIG. 11 may be performed by the battery diagnosis apparatus.

At Step S1110, the processor 320 controls the stimulation application device 301 to intermittently apply a second electric stimulation greater than the first electric stimulation to the target cell BC during a state change period until the electrical state of the target cell BC changes from an initial state to a target state.

In Step S1120, the processor 320 obtains current time series data representing a change history of the current of the target cell BC during the state change period and voltage time series data representing a change history of the full-cell voltage of the target cell BC during rest periods of the second electric stimulation applied during the state change period using the communication unit 310.

Unlike the first embodiment described above, the voltage time series data obtained in Step S1120 includes measurement values of the full-cell voltage measured three or more times per rest period.

In Step S1122, the processor 320 applies the OCV estimation logic to the voltage time series data acquired in Step S1120 to generate the corrected voltage time series data. The OCV estimation logic may be provided to replace a set of measurement values of three full-cell voltage per rest period included in the voltage time series data obtained in Step S1120 with a single OCV value. Accordingly, if a total of X rest periods are granted during the state change period and the full-cell voltage is measured three times per rest period, it will be easily understood by those skilled in the art that the voltage time series data obtained in Step S1120 will include 3X full-cell voltage measurement values, and the corrected voltage time series data will include X OCV values.

In Step S1130, the processor 320 generates a measurement full-cell profile (see M in FIG. 3b) indicating a correspondence between the capacity and the full-cell voltage of the target cell BC based on the current time series data and the corrected voltage time series data.

In Step S1140, the processor 320 analyzes the measurement full-cell profile to estimate the negative electrode loading amount of the target cell BC.

In Step S1150, the processor 320 determines the negative electrode loss rate of the target cell BC based on the estimation value of the negative electrode loading amount.

In Step S1160, the processor 320 limits at least one of an allowable voltage range and an allowable SOC range for the target cell BC based on the estimation value of the negative electrode loading amount. Alternatively or instead, the allowable current for the target cell BC may be limited (down-regulated).

In the method according to FIG. 11, only one of Steps S1150 and S1160 may be executed.

In Step S1170, the processor 320 may transmit the diagnosis result of the target cell BC to the electric vehicle 1 through the communication unit 310. The diagnosis result includes at least one of the negative electrode loading amount, the negative electrode loss rate, the limited allowable voltage range, and the limited allowable SOC range.

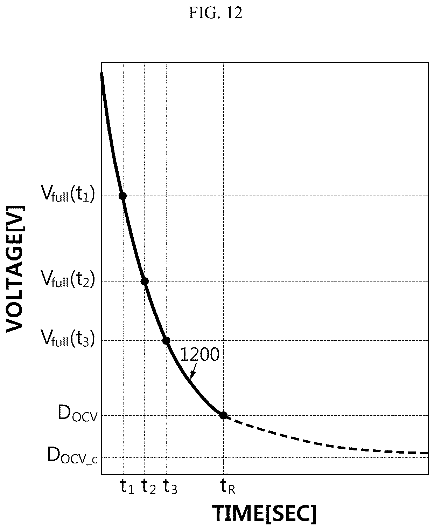

FIG. 12 is a drawing referenced to describe a procedure of correcting voltage time series data performed in Step S1122 of FIG. 11.

The symbol 1200 in FIG. 12 indicates one of the voltage drop segments illustrated in FIG. 3a. $t_R$ indicates a time point at which a reference time has elapsed from the initiation time point of the rest period. The portion up to $t_R$ is depicted as a solid line, and the portion after $t_R$ is depicted as a dotted line.

Referring to FIG. 12, during each rest period, the target cell BC is placed in a no-load state with neither charging nor discharging.

During the no-load state, the full-cell voltage of the target cell BC gradually converges toward the OCV corresponding to the SOC of the target cell BC. The behavior of the full-cell voltage of the target cell BC in a specific rest period may be equivalent to the voltage response of a primary RC circuit, such as Formula 1 below.

<Formula 1>

$$V_{full}(t) = V_{OCV} + (V_S - V_{OCV}) \times e^{-\frac{t}{\tau}}$$

In Formula 1, t is an elapsed time from the start time point of a specific rest period, $V_{full}(t)$ is a full-cell voltage at t, Vocv is an actual OCV, $V_S$ is a full-cell voltage at the start time point of a specific rest period, and $\tau$ is a time constant determined by the internal resistance and capacitance of the target cell BC.

In Formula 1, $V_{full}(t)$ is measurable, so Vocv, $V_S$, and $\tau$ are unknown. Since there are three unknown values, OCV of a specific rest period may be estimated based on $V_{full}(t)$ measured at three different timings in a specific rest period. Formula 2 below may be used to estimate OCV of each rest period.

<Formula 2>

In Formula 1, t is an elapsed time from the start time point of a specific rest period, $V_{full}(t)$ is a full-cell voltage at t, Vocv is an actual OCV, $V_S$ is a full-cell voltage at the start time point of a specific rest period, and $\tau$ is a time constant determined by the internal resistance and capacitance of the target cell BC.

In Formula 1, $V_{full}(t)$ is measurable, so Vocv, $V_S$, and $\tau$ are unknown. Since there are three unknown values, OCV of a specific rest period may be estimated based on $V_{full}(t)$ measured at three different timings in a specific rest period. Formula 2 below may be used to estimate OCV of each rest period.

$$<\text{Formula 2}>$$

$$\frac{V_{full}(t_1) - V_{OCV}}{V_{full}(t_2) - V_{OCV}} = \frac{V_{full}(t_2) - V_{OCV}}{V_{full}(t_3) - V_{OCV}}$$

In Formula 2, $t_1$, $t_2$ and $t_3$ are sequential measurement timings of the full-cell voltage. The time difference between $t_1$ and $t_2$ may be the same as the time difference between $t_2$ and $t_3$. Meanwhile, in FIG. 12, $t_R$ and $t_3$ are illustrated as being different, but it is also possible that $t_R = t_3$. In this case, $V_{full}(t_3) = D_{OCV}$.

The processor 320 may determine $D_{OCV\_C}$ in the same way as Vocv calculated through Formula 2.

The processor 320 may convert the voltage time series data obtained in step S1120 into corrected voltage time series data for step S1130 by repeating the process of replacing three full-cell voltage measurement values ($V_{full}(t_1)$, $V_{full}(t_2)$, $V_{full}(t_3)$) for each rest period with a single OCV value ($D_{OCV\_C}$) for all rest periods. The corrected voltage time series data contains X OCV values. The processor 320 may apply the curve fitting logic to the corrected voltage time series data to generate a measurement full-cell profile M.

For reference, $D_{OCV}$ is the measurement value of the full-cell voltage at the end time point of the rest period (before polarization is completely resolved), while $D_{OCV\_C}$ is the estimation value of the full-cell voltage (i.e., Vocv) in a state where polarization is completely resolved. Therefore, it may be regarded that $D_{OCV\_C}$ is closer to the actual OCV of the target cell BC than $D_{OCV}$.

The embodiments of the present disclosure described hereinabove are not implemented only through the apparatus and method, and may be implemented through programs that perform functions corresponding to the configurations of the embodiments of the present disclosure or recording media having the programs recorded thereon, and such implementation may be easily achieved by those skilled in the art from the disclosure of the embodiments previously described.

While the present disclosure has been hereinabove described with regard to a limited number of embodiments and drawings, the present disclosure is not limited thereto and it is obvious to those skilled in the art that various modifications and changes may be made thereto within the technical aspects of the present disclosure and the equivalent scope of the appended claims.

Additionally, as many substitutions, modifications and changes may be made to the present disclosure described hereinabove by those skilled in the art without departing from the technical aspects of the present disclosure, the present disclosure is not limited by the above-described embodiments and the accompanying drawings, and some or all of the embodiments may be selectively combined to allow various modifications.

**Claims**

1.  A battery diagnosis apparatus comprising:

    a processor configured to control a stimulation application device to intermittently apply a second electric stimulation greater than a first electric stimulation to a target cell during a state change period until an electrical state of the target cell, which is a battery cell to be diagnosed, changes from an initial state to a target state; and
    a communication unit configured to obtain current time series data representing a change history of a current of the target cell during the state change period and voltage time series data representing a change history of a full-cell voltage of the target cell during rest periods of the second electric stimulation applied in the state change period,

wherein the processor is configured to:

generate a measurement full-cell profile representing a correspondence between a capacity and the full-cell voltage of the target cell based on the current time series data and the voltage time series data, and estimate a negative electrode loading amount representing an amount of negative electrode active material per unit area of a negative electrode of the target cell by analyzing the measurement full-cell profile.

2. The battery diagnosis apparatus according to claim 1, wherein the first electric stimulation is an electric stimulation that causes a difference between OCV and CCV equal to or smaller than a reference value in the target cell, and wherein the second electric stimulation is an electric stimulation that causes a difference between the OCV and the CCV greater than the reference value in the target cell.

3. The battery diagnosis apparatus according to claim 1, wherein the first electric stimulation is charging using a first current rate, and
wherein the second electric stimulation is charging using a second current rate that is greater than the first current rate.

4. The battery diagnosis apparatus according to claim 1, wherein the first electric stimulation is a discharge using a first current rate, and
wherein the second electric stimulation is a discharge using a second current rate that is greater than the first current rate.

5. The battery diagnosis apparatus according to claim 1, wherein the voltage time series data are measurement values of the full-cell voltage during the rest periods of the second electric stimulation, which are arranged in time order as OCV of the target cell.

6. The battery diagnosis apparatus according to claim 1, wherein the processor is configured to control the stimulation application device to initiate a rest period of the second electric stimulation whenever a current integration value of the current changes by a threshold integration value.

7. The battery diagnosis apparatus according to claim 6, wherein the processor is configured to control the stimulation application device to resume application of the second electric stimulation when a reference time passes from an initiation time point of the rest period of the second electric stimulation.

8. The battery diagnosis apparatus according to claim 1, wherein the processor is configured to determine a negative electrode loss rate of the target cell based on an estimation value of the negative electrode loading amount.

9. The battery diagnosis apparatus according to claim 1, wherein the processor is configured to limit at least one of an allowable voltage range and an allowable SOC range for the target cell based on an estimation value of the negative electrode loading amount.

10. A charging station comprising the battery diagnosis apparatus according to any one of claims 1 to 9.

11. A cloud server comprising the battery diagnosis apparatus according to any one of claims 1 to 9.

12. A battery diagnosis method comprising:

controlling a stimulation application device to intermittently apply a second electric stimulation greater than a first electric stimulation to a target cell during a state change period until an electrical state of the target cell, which is a battery cell to be diagnosed, changes from an initial state to a target state;
obtaining current time series data representing a change history of a current of the target cell during the state change period and voltage time series data representing a change history of a full-cell voltage of the target cell during rest periods of the second electric stimulation applied in the state change period;
generating a measurement full-cell profile representing a correspondence between a capacity and the full-cell voltage of the target cell based on the current time series data and the voltage time series data; and
estimating a negative electrode loading amount representing an amount of negative electrode active material per unit area of a negative electrode of the target cell by analyzing the measurement full-cell profile.

13. The battery diagnosis method according to claim 12, wherein the voltage time series data are measurement values of the full-cell voltage during the rest periods of the second electric stimulation, which are arranged in time order as OCV of the target cell.

14. The battery diagnosis method according to claim 12, further comprising:
   determining a negative electrode loss rate of the target cell based on an estimation value of the negative electrode loading amount.

15. The battery diagnosis method according to claim 12, further comprising:
   limiting at least one of an allowable voltage range and an allowable SOC range for the target cell based on an estimation value of the negative electrode loading amount.

FIG. 1

FIG. 2

FIG. 3a

FIG. 3b

FIG. 4

FIG. 5

FIG. 6

FIG. 7

EP 4 707 837 A1

FIG. 8

32

FIG. 9

FIG. 10

START

S1010

CONTROL STIMULATION APPLICATION DEVICE TO
INTERMITTENTLY APPLY SECOND ELECTRIC STIMULATION
GREATER THAN FIRST ELECTRIC STIMULATION TO TARGET CELL

S1020

OBTAIN CURRENT TIME SERIES DATA REPRESENTING CHANGE
HISTORY OF CURRENT OF TARGET CELL DURING STATE
CHANGE PERIOD AND VOLTAGE TIME SERIES DATA
REPRESENTING CHANGE HISTORY OF FULL-CELL VOLTAGE OF
TARGET CELL DURING REST PERIODS OF SECOND ELECTRIC
TIMULATION APPLIED IN STATE CHANGE PERIOD

S1030

GENERATE MEASUREMENT FULL-CELL PROFILE REPRESENTING
CORRESPONDENCE BETWEEN CAPACITY
AND FULL-CELL VOLTAGE OF TARGET CELL

S1040

ESTIMATE NEGATIVE ELECTRODE
LOADING AMOUNT OF TARGET CELL

S1050

DETERMINE NEGATIVE
ELECTRODE CAPACITY
LOSS RATE OF TARGET CELL

S1060

LIMIT AT LEAST ONE OF
ALLOWABLE VOLTAGE
RANGE AND ALLOWABLE
SOC RANGE FOR TARGET CELL

S1070

TRANSMIT DIAGNOSIS RESULT OF
TARGET CELL TO ELECTRIC VEHICLE

END

FIG. 11

START

S1110

CONTROL STIMULATION APPLICATION DEVICE TO
INTERMITTENTLY APPLY SECOND ELECTRIC STIMULATION
GREATER THAN FIRST ELECTRIC STIMULATION TO TARGET CELL

S1120

OBTAIN CURRENT TIME SERIES DATA REPRESENTING CHANGE
HISTORY OF CURRENT OF TARGET CELL DURING STATE
CHANGE PERIOD AND VOLTAGE TIME SERIES DATA
REPRESENTING CHANGE HISTORY OF FULL-CELL VOLTAGE OF
TARGET CELL DURING REST PERIODS OF SECOND ELECTRIC
TIMULATION APPLIED IN STATE CHANGE PERIOD

S1122

APPLY OCV ESTIMATION LOGIC TO
VOLTAGE TIME SERIES DATA TO GENERATE CORRECTED
VOLTAGE TIME SERIES DATA

S1130

GENERATE MEASUREMENT FULL-CELL PROFILE REPRESENTING
CORRESPONDENCE BETWEEN CAPACITY
AND FULL-CELL VOLTAGE OF TARGET CELL

S1140

ESTIMATE NEGATIVE ELECTRODE
LOADING AMOUNT OF TARGET CELL

S1150

DETERMINE NEGATIVE
ELECTRODE CAPACITY
LOSS RATE OF TARGET CELL

S1160

LIMIT AT LEAST ONE OF
ALLOWABLE VOLTAGE
RANGE AND ALLOWABLE
SOC RANGE FOR TARGET CELL

S1170

TRANSMIT DIAGNOSIS RESULT OF
TARGET CELL TO ELECTRIC VEHICLE

END

FIG. 12

## INTERNATIONAL SEARCH REPORT

| International application No. |
|---|
| **PCT/KR2024/014522** |

| A. | CLASSIFICATION OF SUBJECT MATTER |
|---|---|

**G01R 31/396**(2019.01)i; **G01R 31/367**(2019.01)i; **G01R 31/392**(2019.01)i; **G01R 31/3842**(2019.01)i; **G01R 31/3828**(2019.01)i; **B60L 58/16**(2019.01)i; **H01M 10/052**(2010.01)i; **G01R 31/36**(2006.01)i; **G01R 31/385**(2019.01)i; **H01M 10/48**(2006.01)i

According to International Patent Classification (IPC) or to both national classification and IPC

| B. | FIELDS SEARCHED |
|---|---|

Minimum documentation searched (classification system followed by classification symbols)

G01R 31/396(2019.01); G01R 19/00(2006.01); G01R 31/36(2006.01); G01R 31/367(2019.01); H01M 10/42(2006.01); H01M 10/44(2006.01); H01M 10/48(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 배터리(battery), 진단(diagnosis), 음극 로딩량(negative electrode loading amount), 풀셀 프로파일(full cell profile), 전기 자극(electrical stimulation)

| C. | DOCUMENTS CONSIDERED TO BE RELEVANT |
|---|---|

| Category* | Citation of document, with indication, where appropriate, of the relevant passages | Relevant to claim No. |
|---|---|---|
| Y | JP 7040601 B2 (MURATA MANUFACTURING CO., LTD.) 23 March 2022 (2022-03-23)<br>See paragraphs [0019]-[0087], claim 2 and figures 1-11. | 1-15 |
| Y | JP 2022-085385 A (TOSHIBA CORP.) 08 June 2022 (2022-06-08)<br>See paragraphs [0014]-[0048] and figures 1-4. | 1-15 |
| A | KR 10-2022-0093840 A (LG ENERGY SOLUTION, LTD.) 05 July 2022 (2022-07-05)<br>See paragraphs [0032]-[0157] and figures 1-13. | 1-15 |
| A | KR 10-2022-0094042 A (LG ENERGY SOLUTION, LTD.) 05 July 2022 (2022-07-05)<br>See paragraphs [0032]-[0203] and figures 1-16. | 1-15 |
| A | KR 10-2023-0057894 A (LG ENERGY SOLUTION, LTD.) 02 May 2023 (2023-05-02)<br>See claims 1-17 and figures 1-10. | 1-15 |

☐ Further documents are listed in the continuation of Box C.    ☑ See patent family annex.

| * | Special categories of cited documents: |
|---|---|
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **17 January 2025** | **17 January 2025** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

## INTERNATIONAL SEARCH REPORT
### Information on patent family members

| International application No. |
| --- |
| **PCT/KR2024/014522** |

| Patent document cited in search report | | | Publication date (day/month/year) | Patent family member(s) | | | Publication date (day/month/year) |
| --- | --- | --- | --- | --- | --- | --- | --- |
| JP | 7040601 | B2 | 23 March 2022 | CN | 111886752 | A | 03 November 2020 |
| | | | | CN | 111886752 | B | 06 August 2024 |
| | | | | EP | 3771020 | A1 | 27 January 2021 |
| | | | | EP | 3771020 | A4 | 15 December 2021 |
| | | | | US | 12071037 | B2 | 27 August 2024 |
| | | | | US | 2021-0001747 | A1 | 07 January 2021 |
| | | | | WO | 2019-181764 | A1 | 26 September 2019 |
| JP | 2022-085385 | A | 08 June 2022 | JP | 7414697 | B2 | 16 January 2024 |
| KR | 10-2022-0093840 | A | 05 July 2022 | CN | 115380221 | A | 22 November 2022 |
| | | | | EP | 4119962 | A1 | 18 January 2023 |
| | | | | EP | 4119962 | A4 | 29 November 2023 |
| | | | | JP | 2023-515838 | A | 14 April 2023 |
| | | | | JP | 7395809 | B2 | 12 December 2023 |
| | | | | US | 12066496 | B2 | 20 August 2024 |
| | | | | US | 2023-0236262 | A1 | 27 July 2023 |
| | | | | US | 2024-0377472 | A1 | 14 November 2024 |
| | | | | WO | 2022-145776 | A1 | 07 July 2022 |
| KR | 10-2022-0094042 | A | 05 July 2022 | CN | 115398256 | A | 25 November 2022 |
| | | | | EP | 4119963 | A1 | 18 January 2023 |
| | | | | EP | 4119963 | A4 | 22 November 2023 |
| | | | | JP | 2023-515831 | A | 14 April 2023 |
| | | | | JP | 7395808 | B2 | 12 December 2023 |
| | | | | US | 12085623 | B2 | 10 September 2024 |
| | | | | US | 2023-0160970 | A1 | 25 May 2023 |
| | | | | US | 2024-0402259 | A1 | 05 December 2024 |
| | | | | WO | 2022-145777 | A1 | 07 July 2022 |
| KR | 10-2023-0057894 | A | 02 May 2023 | CN | 116829966 | A | 29 September 2023 |
| | | | | EP | 4321884 | A1 | 14 February 2024 |
| | | | | EP | 4321884 | A4 | 23 October 2024 |
| | | | | JP | 2024-500893 | A | 10 January 2024 |
| | | | | JP | 7605416 | B2 | 24 December 2024 |
| | | | | US | 2024-0410959 | A1 | 12 December 2024 |
| | | | | WO | 2023-068899 | A1 | 27 April 2023 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020230154880

- KR 1020230133644